# EUROPEAN PATENT APPLICATION

(11) **EP 2 182 396 A1**
(43) Date of publication of application: **05.05.2010**
(21) Application number: 08827767.8
(22) Date of filing: 20.08.2008
(51) Int. Cl.: G02B 5/20, G02B 5/00, G02F 1/1335, G03F 7/004

(54) **RESIN BLACK MATRIX, LIGHT BLOCKING PHOTOSENSITIVE RESIN COMPOSITION, TFT ELEMENT SUBSTRATE AND LIQUID CRYSTAL DISPLAY DEVICE**

(30) Priority: 22.08.2007 JP 2007215973
(71) Applicant: Mitsubishi Chemical Corporation, Minato-ku Tokyo 108-0014 (JP)
(72) Inventor: TOSHIMITSU, Eriko, Yokohama-shi Kanagawa 227-8502 (JP); HIROTA, Takao, Yokohama-shi Kanagawa 227-8502 (JP); KADOWAKI, Masami, Yokohama-shi Kanagawa 227-8502 (JP)
(74) Representative: HOFFMANN EITLE
(86) International application number: PCT/JP2008/064827
(87) International publication number: WO 2009/025297

(57) **Abstract**

Provided is a highly reliable resin black matrix, which has sufficient light-blocking characteristics, suppresses temperature increase due to heat generated by a TFT element and does not have failures of a TFT element substrate and fluctuation in liquid crystal drive. The maximum light transmittance of the resin black matrix in a wavelength range of 400nm-700nm is permitted to be 1% or less and the average light transmittance in a wavelength range of 850nm-3,000nm to be 60% or higher. Alternatively, the minimum light transmittance is permitted to be 50% or more.

## Description

### [Technical Field]

The present invention relates to a resin black matrix and a light-blocking photosensitive resin composition for production thereof. In particular, the present invention relates to a resin black matrix used in an active matrix liquid crystal display device substrate (TFT element substrate) including a switching element (TFT element) composed of a thin-film transistor. The present invention also relates to a TFT element substrate on which the resin black matrix is fabricated and a liquid crystal display device including the TFT element substrate.

### [Background Art]

A resin black matrix for liquid crystal display devices is used to prevent leakage of light from gaps between driving electrodes in liquid crystal display devices. In general, the resin black matrix has a striped or grid pattern composed of a light-blocking material and is formed by photolithography on a transparent substrate that is composed of glass or plastic sheet and is used together with a TFT element substrate.

In order to meet current trends toward higher definition and higher brightness of color liquid crystal display devices, systems that have been proposed for active matrix type liquid crystal display devices include color filter on array technology (COA technology) in which a color filter including both a black matrix and pixel layers are formed on a TFT element substrate side and black matrix on array technology (BOA technology) in which only a black matrix is formed on a TFT element substrate side (for example, refer to Patent Literatures 1 and 2). Since these systems require no alignment margin to a device, they can achieve high aperture rate compared to general systems in which both a black matrix and pixel layers are formed on a substrate opposite to a TFT element substrate, resulting in high brightness.

In response to such a trend, for example, Patent Literatures 3 to 5 each disclose a resin black matrix having a volume resistivity exceeding a certain level to prevent short-circuiting of the electrical circuit after it is directly mounted on a TFT element substrate. Such a disclosed resin black matrix is designed to use carbon black as a light-blocking component. Carbon black, which has significantly high absorbability over a wide range of light wavelength region and significantly high light-blocking ability, is used as a light-blocking component in most of the resin black matrix. For example, Patent Literature 6 discloses a resin black matrix using a light-blocking component of organic pigment instead of carbon black. However, it is not practical in view of light-blocking ability.

[Patent Literature 1] Japanese Unexamined Patent Application Publication No. 10-206888
[Patent Literature 2] Japanese Unexamined Patent Application Publication No. 2002-277899
[Patent Literature 3] Japanese Unexamined Patent Application Publication No. 10-114873
[Patent Literature 4] Japanese Unexamined Patent Application Publication No. 2002-311232
[Patent Literature 5] Japanese Unexamined Patent Application Publication No. 2005-215150
[Patent Literature 6] Japanese Unexamined Patent Application Publication No. 6-51499

### [Disclosure of Invention]

### [Problem to be Solved by the Invention]

A TFT element, which is integrated into high density, is driven at a high rate with heat generation.
Accumulation of heat generated from the element without sufficient cooling in a device leads to increases in on current and off current of the TFTs, resulting in thermal runaway. The thermal runaway further encourages heat generation, and results in various problems, such as destruction of the device, thermal deformation of accessories, e.g., a color filter and a polarizer. Accordingly, it is desirable to dissipate heat generated from the TFT element effectively.

However, carbon black has a characteristic of absorbing not only visible light wavelength region but also near infrared light wavelength region. In the case of a conventional resin black matrix containing carbon black provided on a TFT element substrate, such a property causes accumulation of heat generated from the TFT element without heat dissipation.

The present invention has been accomplished under such a circumstance, and has an object to provide a resin black matrix that can maintain high light-blocking ability of the black matrix and dissipate heat generated from TFT elements even when the matrix is formed on a TFT element substrate. Also the present invention has an object to provide a resin black matrix having sufficiently volume resistivity and a dielectric constant that can prevent short-circuiting or the like.

### [Means for solving the problem]

Through extensive investigation of the problems described above, the present inventors discovered that such problems can be solved by a resin black matrix having a maximum light transmittance of 1% or less over the wavelength range of 400 nm to 700 nm and an average light transmittance of 60% or more over the wavelength range of 850 nm to 3000 nm, or a resin black matrix having a maximum light transmittance of 1% or less over the wavelength range of 400 nm to 700 nm and a minimum light transmittance of 50% or more over the wavelength range of 850 nm to 3000 nm.
Accordingly, the present invention is summarized as follows:

An aspect of the present invention is a resin black matrix that has a maximum light transmittance of 1% or less over the wavelength range of 400 nm to 700 nm and an average light transmittance of 60% or more over the wavelength range of 850 nm to 3000 nm.

Another aspect of the present invention is a resin black matrix that has a maximum light transmittance of 1% or less over the wavelength range of 400 nm to 700 nm and a minimum light transmittance of 50% or more over the wavelength range of 850 nm to 3000 nm.

Herein, the resin black matrix of the present invention preferably has a standard deviation of the light transmittances of 0.1% or less over the wavelength range of 400 nm to 700 nm.
In addition, the resin black matrix of the present invention preferably has a volume resistivity of 1×10¹³ Ω·cm or more and a dielectric constant of 5 or less. Furthermore, the resin black matrix of the present invention is preferably formed on a TFT element substrate.

A further aspect of the present invention is a light-blocking photosensitive resin composition used for formation of the resin black matrix of the present invention, comprising: an alkali-soluble resin, a photopolymerization initiator, an ethylenically unsaturated compound, and a light-blocking component being in the range of 35 wt% to 70 wt% to the total solid content in the composition. Preferably, in the light-blocking photosensitive resin composition, 95% or more of the light-blocking component comprises an organic pigment.

Another aspect of the present invention is a light-blocking photosensitive resin composition comprising an alkali-soluble resin, a photopolymerization initiator, an ethylenically unsaturated compound, and a light-blocking component, wherein 95% or more of the light-blocking component comprises an organic pigment, being a combination of organic pigments selected from at least three groups of the groups (a) to (f):
(a) a red pigment selected from C.I. Pigment Reds 177, 209, 224, and 254;
(b) a blue pigment being C.I. Pigment Blue 15:6;
(c) a green pigment selected from C.I. Pigment Greens 7 and 36;
(d) a yellow pigment selected from C.I. Pigment Yellows 83, 138, 139, 150, and 180;
(e) a purple pigment being C.I. Pigment Violet 23; and
(f) an orange pigment selected from C.I. Pigment Oranges 38 and 71;
such that the composition has a standard deviation of light transmittances of 0.1% or less over the wavelength range of 400 nm to 700 nm.

Herein, the alkali-soluble resin preferably contains an epoxy acrylate resin or a novolak resin.
In addition, the photopolymerization initiator preferably contains an oxime compound.

Another aspect of the present invention is a resin black matrix fabricated from the light-blocking photosensitive resin composition of the present invention.

A further aspect of the present invention is a TFT element substrate on which the resin black matrix of the present invention is fabricated.

Another aspect of the present invention is a liquid crystal display device comprising the resin black matrix of the present invention.

### [Effect of the Invention]

The present invention provides a highly reliable resin black matrix that exhibits sufficient light-blocking ability, can suppress a rise in temperature due to heat generation from TFT elements, and can prevent malfunction of a TFT element substrate and disordered driving of liquid crystal.

### [Brief Description of Drawings]

Fig. 1 is a graph illustrating the relation between the light transmittance (%) and the wavelength of a resin black matrix produced in Example 1 of the present invention.
Fig. 2 is a graph illustrating the relation between the light transmittance (%) and the wavelength of a resin black matrix produced in Example 2 of the present invention.
Fig. 3 is a graph illustrating the relation between the light transmittance (%) and the wavelength of a resin black matrix produced in Example 3 of the present invention.
Fig. 4 is a graph illustrating the relation between the light transmittance (%) and the wavelength of a resin black matrix produced in Example 4 of the present invention.
Fig. 5 is a graph illustrating the relation between the light transmittance (%) and the wavelength of a resin black matrix produced in Comparative Example 1.
Fig. 6 is a graph illustrating the relation between the light transmittance (%) and the wavelength of a resin black matrix produced in Comparative Example 2.
Fig. 7 is a graph illustrating the relation between the light transmittance (%) and the wavelength of a resin black matrix produced in Comparative Example 3.
Fig. 8 is a graph illustrating the relation between the light transmittance (%) and the wavelength of a resin black matrix produced in Comparative Example 4.

### [Best Mode for Carrying Out the Invention]

The embodiments of the present invention will now be described in detail. The following description constitutes mere examples (typical examples) of the embodiments of the present invention, and therefore the present invention should not be limited to these embodiments within the scope of the gist.

### <1. Resin black matrix>

The resin black matrix of the present invention has a maximum light transmittance of 1% or less over the wavelength range of 400 nm to 700 nm and an average light transmittance of 60% or more over the wavelength of 850 nm to 3000 nm.
Alternatively, the resin black matrix of the present invention has a maximum light transmittance of 1% or less over the wavelength range of 400 nm to 700 nm and a minimum light transmittance of 50% or more over the wavelength range of 850 nm to 3000 nm.

### [Light transmittance]

The light transmittance of the resin black matrix of the present invention refers to light transmittance of a resin black matrix (cured film) of the present invention formed on a transparent substrate such as a glass substrate and having a thickness of 3 µm, with reference to that of a substrate not having a resin black matrix, measured with a spectrophotometer.

The average light transmittance refers to the average value of light transmittances over a specific wavelength range. More particularly, it refers to percentage (%) determined from the integral value of a light transmittance curve over a specific wavelength range (a graph plotted by x = wavelength and y = transmittance) divided by the integral value of a light transmittance curve in the case where the light transmittance is 100% over the entire wavelength region of the same wavelength range and multiplied by 100. For example, the term "average light transmittance is 60% or more over the wavelength range of 850 nm to 3000 nm" refers to that the percentage (%) of the integral value of a light transmittance curve over the wavelength range of 850 nm to 3000 nm divided by the integral value of a light transmittance curve in the case where the light transmittance is 100% over the entire wavelength region of the same wavelength range and multiplied by 100 is 60% or more.

The maximum light transmittance refers to the highest value of the light transmittances over a specific wavelength range. More specifically, it refers to the maximum value on a light transmittance curve over a specific wavelength range. For example, the term "maximum light transmittance is 1% or less over the wavelength range of 400 nm to 700 nm" refers to that the maximum value of the light transmittance curve is 1% or less over the wavelength range of 400 nm to 700 nm and that no region exceeds a light transmittance of 1%.

The minimum light transmittance refers to the lowest value of the light transmittances over a specific wavelength range. More specifically, it refers to the minimum value on a light transmittance curve over a specific wavelength range. For example, the term minimum light transmittance is 50% or more over the wavelength range of 850 nm to 3000 nm" refers to that the minimum value of the light transmittance curve is 50% or more over the wavelength range of 850 nm to 3000 nm and that no region is below a light transmittance of 50%.

In the present invention, the term "wavelength range of 400 nm to 700 nm" refers to a so-called visible light wavelength region. The term "resin black matrix having a maximum light transmittance of 1% or less over the wavelength range of 400 nm to 700 nm" refers to a resin black matrix having low light transmittance and high light-blocking ability due to absorption of most of the light in the visible light wavelength region.
The maximum light transmittance of the resin black matrix of the present invention over the wavelength range of 400 nm to 700 nm is 1% or less, preferably 0.9% or less, more preferably 0.8% or less. In particular, it is preferably 0.5% or less, more preferably 0.4% or less over the wavelength range of 400 nm to 650 nm. A maximum light transmittance exceeding this limit may cause light passing through the resin black matrix to affect the contrast and chromaticity of a liquid crystal display device.

On the other hand, the term "wavelength range of 850 nm to 3000 nm" refers to a so called near infrared to infrared light wavelength region. The term "resin black matrix having an average light transmission of 60% or more over the wavelength range of 850 nm to 3000 nm" or "resin black matrix having a minimum light transmission of 50% or more over the wavelength range of 850 nm to 3000 nm" of the present invention refers to a resin black matrix having low light absorption but high light transmission over the wavelength range of near infrared to infrared light wavelength region.
The average light transmittance over the wavelength range of 850 nm to 3000 nm is 60% or more, preferably 70% or more, more preferably 85% or more.
The minimum light transmittance over the wavelength range of 850 nm to 3000 nm is 50% or more, preferably 60% or more, more preferably 70% or more.
An average light transmittance or minimum light transmittance lower than such a lower limit causes the black matrix of the present invention to preclude heat dissipation from TFT elements as heat sources. Such heat generation in the TFT elements causes increases in on current and off current, resulting in thermal runaway. The thermal runaway further encourages heat generation, and results in destruction of the device or thermal deformation of accessories, e.g., a color filter and a polarizer. The resin black matrix of the present invention satisfies at least one, and preferably both, of the average light transmittance and the minimum light transmittance described above.

### [Standard deviation of light transmittances]

The resin black matrix of the present invention preferably has a standard deviation of light transmittances of 0.1% or less over the wavelength range of 400 nm to 700 nm.
The term "standard deviation of (the) light transmittances" refers to a standard deviation of light transmittances over a specific wavelength range. The standard deviation of light transmittances can be determined through measurement of the light transmittances over the wavelength range and then calculation of the standard deviation of these observed values.

The term "resin black matrix having a standard deviation of light transmittances of 0.1% or less over the wavelength range of 400 nm to 700 nm" refers to, so-called, a resin black matrix that exhibits uniform light transmittance and uniform light-blocking effect over the entire visible light wavelength range. The term "uniform light-blocking effect" refers to light-blocking effect without leakage of specific color.

For example, in the case of use of organic pigments as a primary light-blocking component, several types of organic pigments are generally used in combination, so the light transmittance of the resulting resin black matrix is primarily determined by combined light transmittance of these organic pigments. In this case, unlike use of only a single light-blocking component having high light-blocking effect over the visible light wavelength range such as carbon black, a combination of multiple organic pigments exhibiting light absorption (no light transmission) over different narrow ranges generally leads to light-blocking effect over the entire visible light wavelength range, resulting in tendency to nonuniform light transmittance.
In the resin black matrix of the present invention, however, the standard deviation of light transmittances is controlled to 0.1% or less over the wavelength range of 400 nm to 700 nm, so that the resin black matrix exhibiting high and uniform light-blocking effect over the entire visible light wavelength range can be stably provided.

The standard deviation of light transmittances over the wavelength range of 400 nm to 700 nm is preferably 0.1% or less, as described above, and more preferably 0.07% or less, still more preferably 0.05% or less.

### [Volume resistivity and dielectric constant]

The resin black matrix of the present invention preferably has a volume resistivity of 1×10¹³ Ω·cm or more and a dielectric constant of 5 or less.

The volume resistivity is a measure representing the extent of insulation of a material and refers to electrical resistance per unit volume. The volume resistivity can be measured by, for example, a method described in "Denkigakkai Daigakukohza, Denki Densi Zairyo -Kiso kara Shikenho made-(Electrical and Electronic Materials -from Base to Testing Method-)" (Ohmsha, 2006, pp. 223-230) published by The Institute of Electrical Engineers of Japan.
The resin black matrix of the present invention has a volume resistivity of generally 1×10¹³ Ω·cm or more, preferably 1×10¹⁴ Ω·cm or more. A volume resistivity less than these values may cause short circuiting of TFT elements due to leakage current when the resin black matrix is formed directly on a TFT element substrate, for example.

The dielectric constant refers to so-called relative permittivity, which corresponds to a ratio of the dielectric constant of a material to that of vacuum. The dielectric constant can be measured by, for example, a method described in "Denkigakkai Daigakukohza, Denki Densi Zairyo -Kiso kara Shikenho made-(Electrical and Electronic Materials -from Base to Testing Method-)" (Ohmsha, 2006, pp. 233-243) published by The Institute of Electrical Engineers of Japan.
The dielectric constant of the resin black matrix of the present invention is generally 5 or less, preferably 4.5 or less, more preferably 4.0 or less. A higher dielectric constant, for example, may preclude correct transmission of switching of TFT elements when the resin black matrix is formed directly on a TFT element substrate, resulting in disordered driving of liquid crystal.

At a volume resistivity of 1×10¹³ Ω·cm or more and a dielectric constant of 5 or less, the resin black matrix of the present invention is difficult to cause malfunction of TFT element substrate even when the resin black matrix is formed directly on a TFT element substrate like the COA or BOA type, resulting in high reliability of the TFT element substrate. Accordingly, in order to ensure correct operation of the TFT element substrate and to achieve high reliability of the resin black matrix, it is preferred that both the volume resistivity and the dielectric constant be satisfied.

Since the resin black matrix of the present invention has high light-blocking effect over the visible light wavelength range and high heat dissipation (low heat accumulation) due to sufficient light transmittance over the near infrared to infrared wavelength region, it can exhibit high performance when it is used in a liquid crystal display device. Furthermore, the resin black matrix of the present invention is difficult to readily cause short circuiting or malfunction of electrical circuits, resulting in difficulty of thermal runaway and deformation of devices caused by heat accumulation. In conclusion, the resin black matrix is particularly preferred as a resin black matrix for the COA or BOA type in which the resin black matrix is on a TFT element substrate.

### <2. Light-blocking photosensitive resin composition>

The light-blocking photosensitive resin composition of the present invention is a composition for forming the resin black matrix of the present invention that comprises an alkali-soluble resin, a photopolymerization initiator, an ethylenically unsaturated compound, and a light-blocking component, the content of the light-blocking component being 35 wt% to 70 wt% based on the total solid content in the composition.
The light-blocking photosensitive resin composition of another embodiment of the present invention comprises an alkali-soluble resin, a photopolymerization initiator, an ethylenically unsaturated compound, and a light-blocking component, wherein 95% or more of the light-blocking component comprises a combination of organic pigments selected from at least three groups of the groups (a) to (f):
(a) a red pigment selected from C.I. Pigment Reds 177, 209, 224, and 254;
(b) a blue pigment being C.I. Pigment Blue 15:6;
(c) a green pigment selected from C.I. Pigment Greens 7 and 36;
(d) a yellow pigment selected from C.I. Pigment Yellows 83, 138, 139, 150, and 180;
(e) a purple pigment being C.I. Pigment Violet 23; and
(f) an orange pigment selected from C.I. Pigment Oranges 38 and 71;
such that the composition has a standard deviation of light transmittances of 0.1% or less over the wavelength range of 400 nm to 700 nm.
Each component constituting the light-blocking photosensitive resin composition of the present invention will be described in detail below. In the following description, the light-blocking photosensitive resin composition of the present invention may be referred to as merely "the composition of the present invention".

Throughout the specification, the term "(meth)acrylic acid" refers to both acrylic acid and methacrylic acid. The terms "(meth)acryl", "(meth)acrylate", and "(meth)acryloyl group" also have both meanings.
Throughout the specification, the term "(co)polymer" refers to both homopolymer and copolymer.
Throughout the specification, the terms "acid (anhydride)" and "(anhydrous) ... acid" refer to both acid and anhydride thereof.
Throughout the specification, the term "acrylic resin" refers to (co)polymer containing (meth)acrylic acid and (co)polymer containing (meth)acrylate ester having a carboxyl group.
Throughout the specification, the term "monomer" is an opposite word of polymeric substance and includes dimer, trimer, and oligomer, in addition to narrowly-defined monomer.

### [1] Alkali-soluble resin

Any alkali-soluble resin having a carboxyl group or hydroxyl group can be used without restriction in the composition of the present invention. Examples of such resins include epoxy acrylate resins, novolak resins, polyvinylphenol resins, acrylic resins, carboxyl goup-containing epoxy resins, and carboxyl group-containing urethane resins. Among them preferred are epoxy acrylate resins, novolak resins, and acrylic resins, and particularly preferred are epoxy acrylate resins and novolak resins.

### [1-1] Epoxy acrylate resin

Epoxy acrylate resins can be prepared, for example, through addition of an α,β-unsaturated monocarboxylic acid or an α,β-unsaturated monocarboxylic acid ester having a carboxyl group at the ester moiety to an epoxy resin and reaction with polybasic acid or its anhydride to create alkali solubility. Although such a reaction product substantially has no epoxy group and is not limited to "acrylate" in chemical structure, it is idiomatically named epoxy acrylate because of use of an epoxy resin as a raw material and "acrylate" as a typical example.

Examples of preferred epoxy resins as raw materials include (o, m, p-)cresol novolak epoxy resins, phenol novolak epoxy resins, bisphenol A epoxy resins, bisphenol F epoxy resins, trisphenolmethane epoxy resins, biphenyl novolak epoxy resins, naphthalene novolak epoxy resins, epoxy resins prepared by the reaction of epihalohydrin with a polyaddition product of dicyclopentadiene with phenol or cresol, and epoxy resins represented by formula (1) below. The epoxy resins may be used alone or in any combination in any proportion.

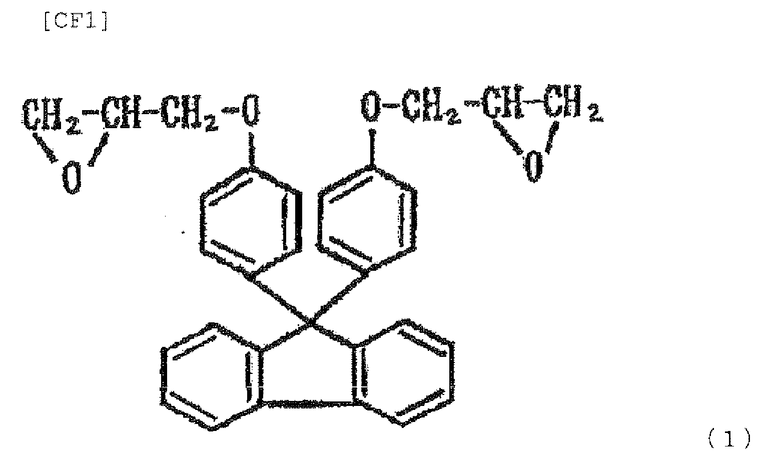

In the phenol epoxy resin, all the phenolic hydroxyl groups need not be replaced with epoxy resins, and thus hydroxyl groups may partially remain. In some cases, partially remaining hydroxyl groups may be preferred for the photosensitive composition in the present invention having a high pigment content and high light-blocking effect. Such a composition has, for example, the following effects: a gap of the polymerization rate between the surface and the bottom during light exposure is easy to be reduced, so that it is advantageous to form shapes for avoiding erosion and reversely tapered shape of the bottom during development.

The weight average molecular weight on the basis of polystyrene standard, determined by gel permeation chromatography (GPC), of the epoxy resin is generally 200 or more, preferably 300 or more, and generally 200000 or less, preferably 100000 or less. A molecular weight below this range will often lead to poor formability of a coating layer, while a molecular weight above this range readily leads to gelation of the resin during addition of the α,β-unsaturated monocarboxylic acid, resulting in difficulty in production.

Examples of α,β-unsaturated monocarboxylic acids include itaconic acid, crotonic acid, cinnamic acid, acrylic acid, and methacrylic acid. Among them preferred are acrylic acid and methacrylic acid, more preferred is acrylic acid, which is highly reactive. The α,β-unsaturated monocarboxylic acids may be used alone or in any combination in any proportion.

Examples of the α,β-unsaturated monocarboxylic acid esters having a carboxyl group at the ester moiety include 2-succinoyloxyethyl acrylate, 2-maleinoyloxyethyl acrylate, 2-phthaloyloxyethyl acrylate, 2-hexahydrophthaloyloxyethyl acrylate, 2-succinoyloxyethyl methacrylate, 2-maleinoyloxyethyl methacrylate, 2-phthaloyloxyethyl methacrylate, 2-hexahydrophthaloyloxyethyl methacrylate, and 2-succinoyloxyethyl crotonate. Preferred are 2-maleinoyloxyethyl acrylate and 2-phthaloyloxyethyl acrylate, and particularly preferred is 2-maleinoyloxyethyl acrylate. The α,β-unsaturated monocarboxylic acid esters having a carboxyl group at the ester moiety may be used alone or in any combination in any proportion.

Addition reaction of the α,β-unsaturated monocarboxylic acid or the α,β-unsaturated monocarboxylic acid ester having a carboxyl group at the ester moiety with the epoxy resin can be achieved by any known process, for example, at a temperature of 50 to 150°C in the presence of an esterification catalyst. Examples of the esterification catalysts include tertiary amines such as triethylamine, trimethylamine, benzyldimethylamine, and benzyldiethylamine; and quaternary ammonium salts such as tetramethylammonium chloride, tetraethylammonium chloride, and dodecyltrimethylammonium chloride. The esterification catalysts may be used alone or in any combination in any proportion.

The α,β-unsaturated monocarboxylic acid or the α,β-unsaturated monocarboxylic acid ester having a carboxyl group at the ester moiety is used in an amount of generally 0.5 equivalent or more, preferably 0.7 equivalent or more and generally 1.2 equivalent or less, preferably 1.1 equivalent or less per equivalent of the epoxy group in the raw epoxy resin. A smaller amount of α,β-unsaturated monocarboxylic acid or α,β-unsaturated monocarboxylic acid ester having a carboxyl group at the ester moiety may lead to insufficient introduction of unsaturated groups, and thus insufficient reaction with polybasic acid anhydride in the subsequent step. Furthermore, large amounts of remaining epoxy groups are disadvantageous. On the other hand, when the α,β-unsaturated monocarboxylic acid or the α,β-unsaturated monocarboxylic acid ester having a carboxyl group at the ester moiety is used in a larger amount, the compound may remain as unreacted material. Both cases may cause poor curing characteristics.

Preferred polybasic acids or anhydrides thereof to be further added to the epoxy resin to which the α,β-unsaturated carboxylic acid or the α,β-unsaturated monocarboxylic acid ester having a carboxyl group at the ester moiety is added are for example polybasic acid anhydride. Examples of polybasic acid anhydrides include maleic anhydride, succinic anhydride, itaconic anhydride, phthalic anhydride, tetrahydrophthalic anhydride, hexahydrophthalic anhydride, pyromellitic anhydride, trimellitic anhydride, benzophenonetetracarboxylic dianhydride, methylhexahydrophthalic anhydride, endomethylenetetrahydrophthalic anhydride, chlorendic anhydride, methyltetrahydrophthalic anhydride, and biphenyltetracarboxylic dianhydride. Among them preferred are maleic anhydride, succinic anhydride, itaconic anhydride, phthalic anhydride, tetrahydrophthalic anhydride, hexahydrophthalic anhydride, pyromellitic anhydride, trimellitic anhydride, and biphenyltetracarboxylic dianhydride, and particularly preferred are tetrahydrophthalic anhydride and biphenyltetracarboxylic dianhydride. Either or both of the polybasic acids and anhydrides thereof may be used. The polybasic acids or anhydrides thereof may be used alone or in any combination in any proportion.

Any known process may be applied to addition reaction of the polybasic acid anhydride. For example, the reaction can be completed through a continuous reaction under the same conditions as those in the addition reaction of the α,β-unsaturated carboxylic acid or ester thereof. The polybasic acid anhydride is added in an amount such that the acid value of the resulting epoxy acrylate resin is preferably 10 mgKOH/g or more, more preferably 20 mgKOH/g or more, and preferably 150 mgKOH/g or less, more preferably 140 mgKOH/g or less. An acid value of the resin less than the above range tends to cause poor alkali developing ability, while an acid value exceeding the range may cause poor curing ability.
In the present invention, final products having the same structure produced without use of epoxy resins can also be categorized as epoxy acrylate resin.

### [1-2] Novorak resins

The novorak resins are, for example, prepared by polycondensation of at least one of the phenols, such as phenol, o-cresol, m-cresol, p-cresol, 2,5-xylenol, 3,5-xylenol, o-ethylphenol, m-ethylphenol, p-ethylphenol, propylphenol, n-butylphenol, t-butylphenol, 1-naphthol, 2-naphthol, 4,4'-biphenyldiol, bisphenol A, pyrocatechol, resorcinol, hydroquinone, pyrogallol, 1,2,4-benzenetriol, benzoic acid, 4-hydroxyphenylacetic acid, salicylic acid, and phloroglucinol with at least one of the aldehydes such as formaldehyde, paraformaldehyde, acetaldehyde, paraldehyde, propionaldehyde, benzaldehyde, salicylaldehyde, and furfural or ketones such as acetone, methyl ethyl ketone, and methyl isobutyl ketone in the presence of acid catalysts.

The reaction of phenols with aldehydes or ketones is generally performed under nonsolvent conditions or in a solvent. Resol resins prepared by polycondensation using an alkaline catalyst instead of an acid catalyst in the polycondensation of a novorak resin can also be used. In addition, the phenols may be substituted, if necessary. Furthermore, any aromatic compound other than phenols may be added to the reaction system for polycondensation. Any other process that can produce the same final skeleton may be used instead of condensation polymerization.

In order to enhance solubility of novorak resin to alkaline, carboxylic acids may be added to part of the phenolic hydroxyl groups. Examples of carboxylic acids include succinic acid, maleic acid, itaconic acid, phthalic acid, tetrahydrophthalic acid, 3-methyltetrahydrophthalic acid, 4-methyltetrahydrophthalic acid, 3-ethyltetrahydrophthalic acid, 4-ethyltetrahydrophthalic acid, hexahydrophthalic acid, 3-methylhexahydrophthalic acid, 4-methylhexahydrophthalic acid, 3-ethylhexahydrophthalic acid, 4-ethylhexahydrophthalic acid, and anhydride thereof. The carboxylic acids may be used alone or in any combination in any proportion.

The phenol groups in the novorak resin may be partly substituted such that the resin has a variety of functions, if necessary. For example, glycidyl methacrylate is added so that its side chains have double bonds.
The novorak resins may be used alone or in any combination in any proportion.

The weight average molecular weight (hereinafter referred to as "Mw") of the novorak resin by gel permeation chromatography (GPC) on the basis of polystyrene standard is generally 1,000 or more and generally 20,000 or less, preferably 10,000 or less, more preferably 8,000 or less. A smaller Mw tends to decrease the sensitivity, whereas a larger Mw may cause poor developing ability.

The novorak resin can effectively avoid eccentric curing on the surface, formation of bored bottom shape, and formation of reversely tapered shape due to poor thermal flowability, which are sometimes observed in a high-sensitivity composition containing a large amount of light-blocking component and having high light-blocking ability of the present invention.

### [1-3] Acrylic resin

Acrylic resins used contain monomer having carboxyl groups or phenolic hydroxyl groups at main or side chains for high alkaline solubility. Among them, preferred are acrylic resins containing carboxyl groups that facilitate development in a solution containing a large amount of alkali. Examples of such resins include acrylic acid (co)polymers and styrene-maleic anhydride resins. Among them, particularly preferred are (co)polymers containing (meth)acrylic acid and (co)polymers containing (meth)acrylate esters having carboxylic groups. The acrylic resins can exhibit high developing ability and high transparency, can produce copolymers having various properties in combination with a variety of monomers, and can fascilitate controlling of the production method.
The acrylic resin of the present invention, for example, may contain the following monomers for high alkali solubility.

Examples of such monomers include carboxylic acids containing unsaturated groups such as (meth)acrylic acid, cinnamic acid, maleic acid, fumaric acid, maleic anhydride, itaconic acid; succinic acid 2-(meth)acryloyloxyethyl ester, adipic acid 2-acryloyloxyethyl ester, phthalic acid 2-(meth)acryloyloxyethyl ester, hexahydrophthalic acid 2-(meth)acryloyloxyethyl ester, maleic acid 2-(meth)acryloyloxyethyl ester, succinic acid 2-(meth)acryloyloxypropyl ester, adipic acid 2-(meth)acryloyloxypropyl ester, hexahydrophthalic acid 2-(meth)acryloyloxypropyl ester, phthalic acid 2-(meth)acryloyloxypropyl ester, maleic acid 2-(meth)acryloyloxypropyl ester, succinic acid 2-(meth)acryloyloxybutyl ester, adipic acid 2-(meth)acryloyloxybutyl ester, hexahydrophthalic acid 2-(meth)acryloyloxybutyl ester, phthalic acid 2-(meth)acryloyloxybutyl ester, and maleic acid (2-(meth)acryloyloxybutyl) ester.
These monomers may be used alone or in any combination in any proportion.

The acrylic resin of the present invention preferably contains the following monomers as copolymerizing components in addition to the monomers described above. Examples of such monomer include styrenic monomers such as styrene, α-methylstyrene, and vinyltoluene; (meth)acrylic acid esters such as methyl (meth)acrylate, ethyl (meth)acrylate, propyl (meth)acrylate, allyl (meth)acrylate, butyl (meth)acrylate, 2-ethylhexyl (meth)acrylate, hydroxyethyl (meth)acrylate, hydroxypropyl (meth)acrylate, benzyl (meth)acrylate, hydroxyphenyl (meth)acrylate, methoxyphenyl (meth)acrylate, and tricyclo[5.2.1.0]decan-8-yl (meth)acrylate; compounds prepared by addition of lactones such as ε-caprolactone, β- propiolactone, γ-butyrolactone, and δ-valerolactone to (meth)acrylic acid; acrylonitriles such as acrylonitrile and (meth)acrylonitrile; acrylamides such as (meth)acrylamide, N-methylolacrylamide, N,N-dimethylacrylamide, N-methacriloylmorpholine, N,N-dimethylaminoethyl (meth)acrylate, and N,N-dimethylaminoethylacrylamide; and acid vinyl such as vinyl acetate, vinyl versatate, vinyl propionate, vinyl cinnamate, and vinyl pivarate. These may be used alone or in any combination in any proportion.

Preferred acrylic resins that improve the strength of a coating film on a substrate are prepared by copolymerization of at least one monomer (a) and at least one monomer (b) described below.

Monomers (a): monomers having phenyl groups such as styrene, α-methylstyrene, benzyl (meth)acrylate, hydroxyphenyl (meth)acrylate, methoxyphenyl (meth)acrylate, hydroxyphenyl (meth)acrylamide, and hydroxyphenyl (meth)acrylsulfoamide.
Monomers (b): (meth)acrylic acid, (meth)acrylic acid 2-(meth)acryloyloxyethyl ester, or (meth)acrylic acid esters having carboxyl groups such as succinic acid 2-(meth)acryloyloxyethyl ester, adipic acid 2-(meth)acryloyloxyethyl ester, phthalic acid 2-(meth)acryloyloxyethyl ester, hexahydrophthalic acid 2-(meth)acryloyloxyethyl ester, and maleic acid 2-(meth)acryloyloxyethyl ester.

In the production of the acrylic resins, the monomer
(a) is used in an amount of generally 10 mole % or more, preferably 20 mole % or more, more preferably 30 mole % or more, and generally 98 mole % or less, preferably 80 mole % or less, and more preferably 70 mole % or less. The monomer (b) is used in an amount of generally 2 mole % or more, preferably 20 mole % or more, more preferably 30 mole % or more, and generally 90 mole % or less, preferably 80 mole % or less, more preferably 70 mole % or less.

The acrylic resins preferably contain acrylic resins containing ethylenic double bonds on their side chains. Use of such acrylic resins can improve photocuring ability of the composition of the present invention, resulting in a further improvement in adhesion to the substrate.

Methods of introduction of ethylenic double bonds on the side chains of the acrylic resins are disclosed, for example, in Japanese Examined Patent Application Publication No. 50-34443, and Japanese Examined Patent Application Publication No. 50-34444. More specifically,
(1) a method of a reaction of carboxylic groups contained in the acrylic resin with a compound having both a glycidyl or epoxycyclohexyl group and a (meth)acryloyl group (2) a method of a reaction of hydroxyl groups contained in the acrylic resin with acrylic acid chloride, for example.

More specifically, acrylic resins having ethylenic double bonds on their side chains can be prepared by the reaction of acrylic resins having carboxyl or hydroxyl group with one or more compounds such as glycidyl (meth)acrylate, allyl glycidyl ether, glycidyl α-ethylacrylate, crotonyl glycidyl ether, (iso)crotonic acid glycidyl ether, (3,4-epoxycyclohexyl) methyl (meth)acrylate, (meth)acrylic acid chloride, and (meth)allyl chloride. Among them, preferred are reaction products of acrylic resins having carboxylic or hydroxyl groups with alicyclic epoxy compounds such as (3,4-epoxycyclohexyl)methyl (meth)acrylate.

In the preliminary introduction of ethylenic double bonds into acrylic resins having carboxyl or hydroxyl groups, it is preferred that compounds having generally 2 mole % or more, preferably 5 mole % or more, and generally 50 mole % or less, preferably 40 mole % or less of ethylenic double bonds be bonded to the carboxyl or hydroxyl groups of the acrylic resins. The content of the carboxyl groups on the basis of acid value preferably ranges from 5 to 200 mg-KOH/g. An acid value of less than 5 mg-KOH/g may yield an insoluble product that cannot be dissolved in alkaline developers, whereas an acid value exceeding 200 mg-KOH/g may be difficult to form images due to excessively high solubility to developing solutions.

When acrylic resins used in the present invention have phenolic hydroxyl groups, the resins have advantages similar to those of the novorak resins. In particular, useful are acrylic resins prepared using vinyl monomers having aromatic hydroxyl groups on their side chains, specifically, used as part of copolymerizing components, o, m, p-hydroxyphenyl methacrylamide, o, m, p-hydroxystyrene, and o, m, p-hydroxypherzylmaleimide. Resins containing such components have a disadvantage of low sensitivity as photopolymerizable compositions, but can prevent formation of bored shapes, by a development, that tends to occur near a substrate due to local curing on a surface in a light-blocking photosensitive resin composition of the present invention.
The acrylic resins may be used alone or in any combination in any proportion.

The weight average molecular weight (Mw) of the acrylic resin determined by gel permeation chromatography (GPC) on the basis of polystyrene standard preferably ranges from 1,000 to 100,000. A weight average molecular weight of less than 1,000 makes it difficult to form a uniform coating film, whereas a weight average molecular weight exceeding 100,000 may lead to poor developing ability.

### [1-4] Polyvinylphenol resin

Examples of polyvinylphenol resins include homopolymers or copolymers prepared by polymerization of one or more hydroxystyrenes such as o-hydroxystyrene, m-hydroxystyrene, p-hydroxystyrene, dihydroxystyrene, trihydroxystyrene, tetrahydroxystyrene, penthydroxystyrene, o-hydroxy-α-methylstyrene, m-hydroxy-α-methylstyrene, p-hydroxy-α-methylstyrene, 2-(o-hydroxyphenyl)propylene, 2-(m-hydroxyphenyl)propylene, and 2-(p-hydroxyphenyl)propylene (these compounds may have a substituent such as a halogen atom, e.g., chlorine, bromine, iodine, or fluorine, or an alkyl group having one to four carbon atoms on the benzene ring), with one or more comonomers of styrenes such as styrene and α-methylstyrene or acrylic acid derivatives such as (meth)acrylic acid, methyl (meth)acrylate, ethyl (meth)acrylate, butyl (meth)acrylate, hydroxyethyl (meth)acrylate, tricyclo[5.2.1.0]decan-8-yl (meth)acrylate, glycidyl (meth)aorylate, and hydroxyphenyl (meth)acrylamide in the presence of a radical initiator or a cation polymerization initiator.

In order to enhance solubility of the polyvinyl phenol resin in alkali, carboxylic acid may be added to part of the phenolic hydroxyl group. Examples of carboxylic acids include succinic acid, maleic acid, itaconic acid, phthalic acid, tetrahydrophthalic acid, 3-methyltetrahydrophthalic acid, 4-methyltetrahydrophthalic acid, 3-ethyltetrahydrophthalic acid, 4-ethyltetrahydrophthalic acid, hexahydrophthalic acid, 3-methylhexahydrophthalic acid, 4-methylhexahydrophthalic acid, 3-ethylhexahydrophthalic acid, 4-ethylhexahydrophthalic acid, and anhydrides thereof. The carboxylic acids may be used alone or in any combination in any proportion.
Also, the polyvinylphenol resins may be used alone or in any combination in any proportion.

The weight average molecular weight (Mw) of the polyvinylphenol resin by gel permeation chromatography (GPC) is generally 2,000 or more, and generally 50,000 or less, preferably 20,000 or less. A Mw of less than 2,000 may lead to decreased sensitivity, whereas a Mw exceeding 50,000 may lead to poor developing ability.

### [1-5. Other items on alkali-soluble resin]

The alkali-soluble resin described above may be used alone or in any combination in any proportion.
As described above, use of a resin having phenolic hydroxyl group is preferred to reduce polymerization gap between the surface and the bottom and thus to form a satisfactory shape.

The proportion of the alkali-soluble resin to the total solid content in the light-blocking photosensitive resin composition of the present invention is generally 10 wt% or more, preferably 15 wt% or more, and generally 70 wt% or less, preferably 50 wt% or less. An alkali-soluble resin content exceeding this proportion may lead to insufficient sensitivity and light-blocking ability. On the other hand, a content less than the proportion may lead to formation of an unsatisfactory shape of the resin black matrix.

### [2] Photopolymerization initiator

The photopolymerization initiator used in the present invention refers to a compound that generates radicals that induce polymerization of ethylenically unsaturated bonds by ultraviolet or heat.

Examples of the photopolymerization initiator used in the present invention are as follows:
Halomethylated triazine derivatives, e.g., 2-(4-methoxyphenyl)-4,6-bis(trichloromethyl)-s-triazine, 2-(4-methoxynaphthyl)-4,6-bis(trichloromethyl)-s-triazine, 2-(4-ethoxynaphthyl)-4,6-bis (trichloromethyl)-s-triazine, and 2-(4-ethoxycarbonylnaphthyl)-4,6-bis(trichloromethyl)-s-triazine;
Halomethylated oxadiazole derivatives;
Imidazole derivatives, e.g., 2-(o-chlaraphenyl)-4,5-diphenylimidazole dimers, 2-(o-chloroprenyl)-4,5-bis(3'-methoxyphenyl) imidazole dimers, 2-(o-fluorophenyl)-4,5-diphenylimidazole dimers, 2-(o-methoxyphenyl)-4,5-diphenylimidazole dimers, and 2-(o-methoxyphenyl)-4,5-diphenylimidazole dimers;
Benzoin ethers, e.g., benzoin methyl ether, benzoin phenyl ether, benzoin isobutyl ether, and benzoin isopropyl ether;

Anthraquinone derivatives e.g., 2-methylanthraquinone, 2-ethylanthraquinone, 2-tert-butylanthraquinone, and 1-chloroanthraquinone;
Benzanthrone derivatives;
Benzophenone derivatives, e.g., benzophenone, Michler's ketone, 2-methylbenzophenone, 3-methylbenzophenone, 4-methylbenzophenone, 2-chlorobenzophenone, 4-bromobenzophenone, and 2-carboxybenzophenone;
Acetophenone derivatives, e.g., 2,2,-dimethoxy-2-phenylacetophenone, 2,2-diethoxyacetophenone, 1-hydroxycyclohexyl phenyl ketone, α-hydroxy-2-methyl phenyl propanone, 1-hydroxy-1-methylethyl (p-isopropylphenyl) ketone, 1-hydroxy 1-(p-dodecylphenyl) ketone, 2-methyl-(4'-(methylthio)phenyl)-2-morpholino-1-propanone, and 1,1,1,-trichloromethyl (p-butylphenyl) ketone;
Thioxanthone derivatives, e.g., thioxanthone, 2-ethylthioxanthone, 2-isopropylthioxanthone, 2-chlorothioxanthone, 2,4-dimethylthioxanthone, 2,4-diethylthioxanthone, and 2,4-diisopropylthioxanthone;
Benzoic acid ester derivatives, e.g., ethyl p-dimethylaminobenzoate and ethyl p-diethylaminobenzoate;

Acridine derivatives, e.g., 9-phenylacridine and 9-(p-methoxyphenyl)acridine;
Phenazine derivatives, e.g., 9,10-dimethylbenzphenazine;
Titanocene derivatives, e.g., di-cyclopentadienyl-Ti-dichloride, di-cyclopentadienyl-Ti-bis-phenyl, di-cyclopentadienyl-Ti-bis-2,3,4,5,6-pentafluorophen-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-2,6-difluorophen-1-yl, di-cyclopentadienyl-Ti-2,4-difluorophen-1-yl, di-methylcyclopentadienyl-Ti-bis-2,3,4,5,6-pentafluorophen-1-yl, di-methylcyclopentadienyl-Ti-bis-2,6-difiuorophen-1-yl, and di-cyolopentadienyl-Ti-2,6-difluoro-3-(1-pyrrolyl)-phen-1-yl; and
α-Aminoalkylphenone compounds, e.g., 2-methyl-1-[4-(methylthio)phenyl]-2-morpholinopropan-1-one, 2-benzyl-2-dimethylamino-1-(4-morpholinophenyl)-butanone-1, 2-benzyl-2-dimethylamino-1-(4-morpholinophenyl)butan-1-one, 4-dimethyl aminoethylbenzoate, 4-dimethyl aminoisoamylbenzoate, 4-diethylaminoacetophenone, 4-dimethylaminopropiophenone, 2-ethylhexyl-1,4-dimethylaminobenzoate, 2,5-bis(4-diethylaminobenzal)cyclohexanone, 7-diethylamino-3-(4-diethylaminobenzoyl)coumarin, and 4-(diethylamino)chalcone.

In particular, oxime derivatives (oxime compounds) are useful in view of sensitivity. These are particularly useful in the case of high light-blocking ability or use of an alkali-soluble resin containing phenolic hydroxyl groups which are disadvantageous in sensitivity.

Examples of oxime compounds include compounds having a structural unit represented by formula (2), preferably, oxime ester compounds represented by formula (3):

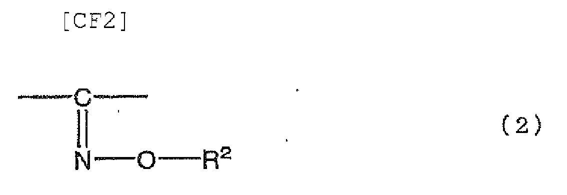

In formula (2), R² is an optionally substituted heteroaryl having the carbon number of 3∼20, alkanoyl having the carbon number of 2∼12, heteroarylalkanoyl having the carbon number of 4∼20, alkenoyl having the carbon number of 3∼25, cycloalkanoyl having the carbon number of 4∼8, alkoxycarbonylalkanoyl having the carbon number of 4∼20, aryloxycarbonylalkanoyl having the carbon number of 9∼20, heteroaryloxycarbonylalkanoyl having the carbon number of 6∼20, aminocarbonyl having the carbon number of 1∼10, aryloyl having the carbon number of 7∼20, heteroaryloyl having the carbon number of 4∼20, alkoxycarbonyl having the carbon number of 2∼10 or aryloxycarbonyl group having the carbon number of 7∼20.

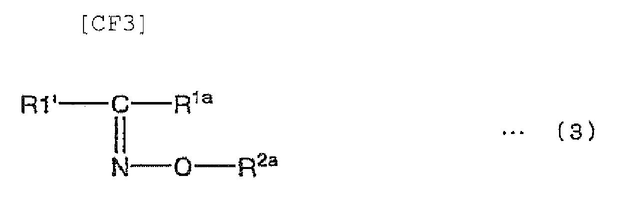

In formula (3), R^{1a} is an optionally substituted alkenyl having the carbon number of 2∼25, heteroarylalkyl having the carbon number of 4∼20, alkoxycarbonylalkyl having the carbon number of 3∼20, aryloxycarbonylalkyl having the carbon number of 8∼20, heteroaryloxycarbonylalkyl or heteroarylthioalkyl having the carbon number of 5∼20, amino having the carbon number of 0∼20, aminoalkyl having the carbon number of 1∼20, alkanoyl having the carbon number of 2∼12, alkenoyl having the carbon number of 3∼25, cycloalkanoyl having the carbon number of 4∼8, aryloyl having the carbon number of 7∼20, heteroaryloyl having the carbon number of 4∼20, alkoxycarbonyl having the carbon number of 2∼10, or aryloxycarbonyl group having the carbon number of 7∼20. R^{1a} may form a ring together with R1'. Its linking group may have an optionally substituted alkylene having the carbon number of 1∼10, polyethylene (-(CH=CH)ᵣ-), polyethynylene (-(C≡C)ᵣ-) group, or a combination thereof (r is an integer of 0 to 3).
R1' is any substituent including an aromatic ring or heteroaromatic ring.
R^{2a} is optionally substituted heteroaryl having the carbon number of 3∼20, alkanoyl having the carbon number of 2∼12, heteroarylalkanoyl having the carbon number of 4∼20, alkenoyl having the carbon number of 3∼25, cycloalkanoyl having the carbon number of 4∼8, alkoxycarbonylalkanoyl having the carbon number of 4∼20, aryloxycarbonylalkanoyl having the carbon number of 9∼20, heteroaryloxycarbonylalkanoyl having the carbon number of 6∼20, aminocarbonyl having the carbon number of 1∼10, aryloyl having the carbon number of 7∼20, heteroaryloyl having the carbon number of 4∼20, alkoxycarbonyl having the carbon number of 2∼10, or aryloxycarbonyl group having the carbon number of 7∼20.

Nonlimiting examples of the oxime ester compounds include the following compounds:

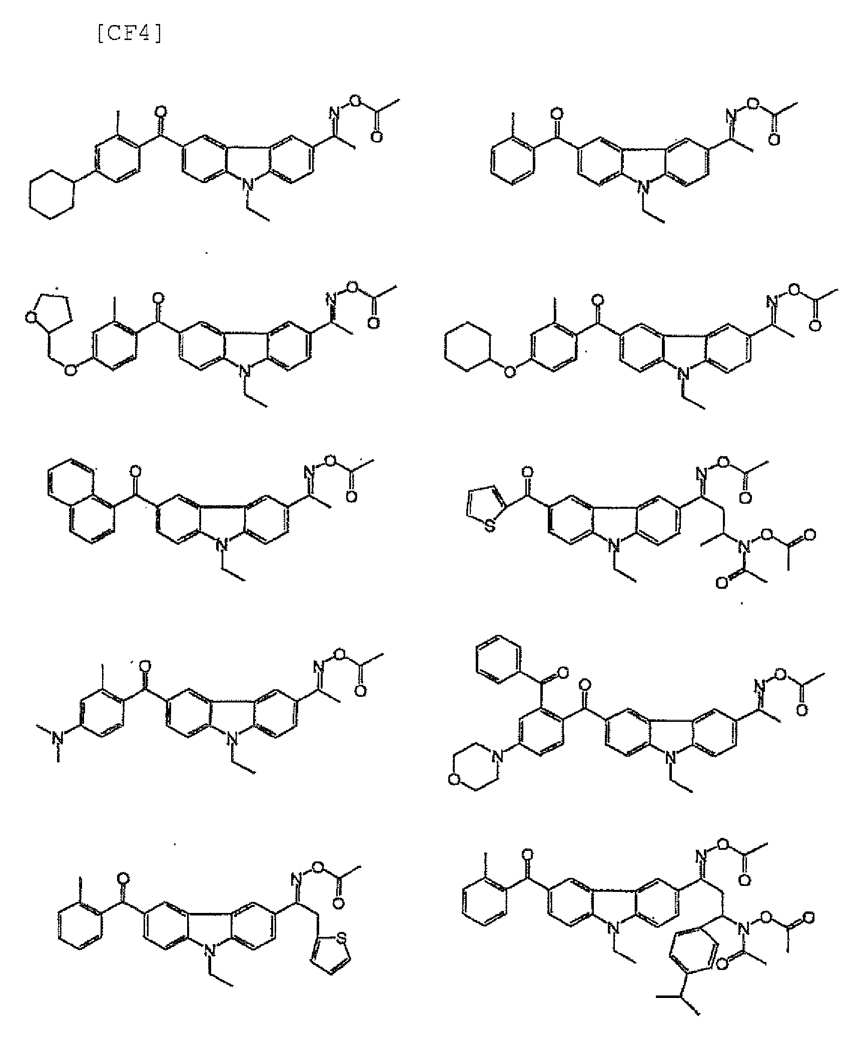

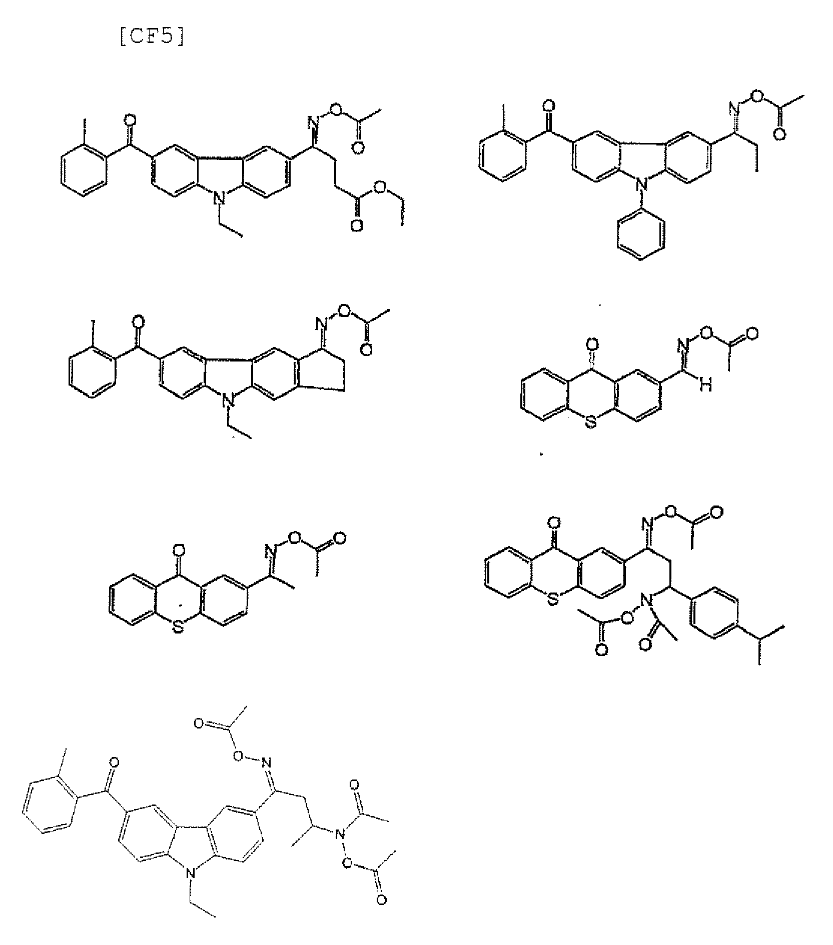

These oxime ester compounds are some of the compounds disclosed in, for example, Japanese Unexamined Patent Application Publication Nos. 2000-80068 and 2006-36750.

The photopolymerization initiators may be used alone or in any combination in any proportion.
The proportion of the photopolymerization initiator to the total solid content in the light-blocking photosensitive resin composition of the present invention is generally 0.4 wt% or more, preferably 0.5 wt% or more, and generally 7 wt% or less, preferably 5 wt% or less. A larger proportion of the photopolymerization initiator tends to decrease the developing rate, whereas a smaller proportion may lead to insufficient sensitivity and thus formation of an unsatisfactory shape.

### [3] Ethylenically unsaturated compound

The photopolymerization initiator described above is used together with an ethylenically unsaturated compound.
The ethylenically unsaturated compound refers to a compound having one or more ethylenically unsaturated bonds in a molecular. Preferred compounds have two or more ethylenically unsaturated bonds in a molecule in view of polymerization ability, crosslinking ability, and thus a enhancing difference in solubility in developer between the exposed portion and the unexposed portion. More preferred unsaturated bonds are (meth)acrylate compounds derived from the (meth)acryloyloxy group.

Examples of compounds having one or more ethylenically unsaturated bonds in a molecule include unsaturated carboxylic acids such as (meth)acrylic acid, crotonic acid, isocrotonic acid, maleic acid, itaconic acid, citraconic acid, and alkyl esters thereof, (meth)acrylonitrile, (meth)acrylamide, styrene.

Typical examples of compounds having two or more ethylenically unsaturated bonds in a molecule include esters of unsaturated carboxylic acids with polyhydroxy compounds, phosphates containing (meth)acryloyloxy groups, urethane (meth)acrylates of hydroxy (meth)acrylate compounds with polyisocyanate compounds, and epoxy (meth)acrylates of (meth)acrylic acid or hydroxy (meth)acrylate compounds with polyepoxy compounds.

Specific examples of esters of unsaturated carboxylic acids with polyhydroxy compounds are as follows:
Reaction products of unsaturated carboxylic acids with polyvalent alcohols: Examples of polyvalent alcohols include ethylene glycol, polyethylene glycol (additional degree of 2 to 14), propylene glycol, polypropylene glycol (additional degree of 2 to 14), trimethylene glycol, tetramethylene glycol, hexamethylene glycol, trimethylolpropane, glycerol, pentaerythritol, and dipentaerythritol.

The reaction product of unsaturated carboxylic acid with alkylene oxide adduct of polyvalent alcohol: The polyvalent alcohols are the same as that described above. Examples of alkylene oxide adducts include ethylene oxide adducts and propylene oxide adducts.

The reaction product of unsaturated carboxylic acid with alcoholamine: Examples of alcoholamines include diethanolamine and triethanolamine.

Specific examples of esters from unsaturated carboxylic acids and polyhydroxy compounds include ethylene glycol di(meth)acrylate, diethylene glycol di(meth)acrylate, propylene glycol di(meth)acrylate, trimethylolpropane di(meth)acrylate, trimethylolpropane tri(meth)acrylate, trimethylolpropane ethylene oxide added tri(meth)acrylate, glycerol di(meth)acrylate, glycerol tri(meth)acrylate, glycerol propylene oxide added tri(meth)acrylate, pentaerythritol di(meth)acrylate, pentaerythritol tri(meth)acrylate, pentaerythritol tetra(meth)acrylate, dipentaerythritol penta(meth)acrylate, and dipentaerythritol hexa(meth)acrylate, and crotonate, isocrotonate, maleate, itaconate, and citraconate of these polyhydroxy compounds.

Examples of other esters from unsaturated carboxylic acids and polyhydroxy compounds include reaction products of unsaturated carboxylic acids with aromatic polyhydroxy compounds such as hydroquinone, resorcin, pyrogallol, bisphenol F, and bisphenol A, or ethylene oxide adducts thereof. Examples of such compounds include bisphenol A di(meth)acrylate, bisphenol A bis[oxyethylene (meth)acrylate], and bisphenol A bis[glycidyl ether (meth) acrylate] .
Reaction products of, for example, the unsaturated carboxylic acids described above with heterocyclic polyhydroxy compounds such as tris(2-hydroxyethyl)isocyanurate can also be used. Examples of such compounds include di(meth)acrylate and tri(meth)acrylate of tris(2-hydroxyethyl)isocyanurate.
Reaction products of, for example, unsaturated carboxylic acids, polyvalent carboxylic acid, and polyhydroxy compounds can also be used. Examples of such compounds include a condensation product of (meth)acrylic acid, phthalic acid and ethylene glycol, a condensation product of (meth)acrylic acid, maleic acid, and diethylene glycol, a condensation product of (meth)acrylic acid, terephthalic acid, and pentaerythritol, and a condensation product of (meth)acrylic acid, adipic acid, butanediol, and glycerol.

Preferred phosphates containing (meth)acryloyloxy groups are represented by the following general formulae (4), (5), and (6):

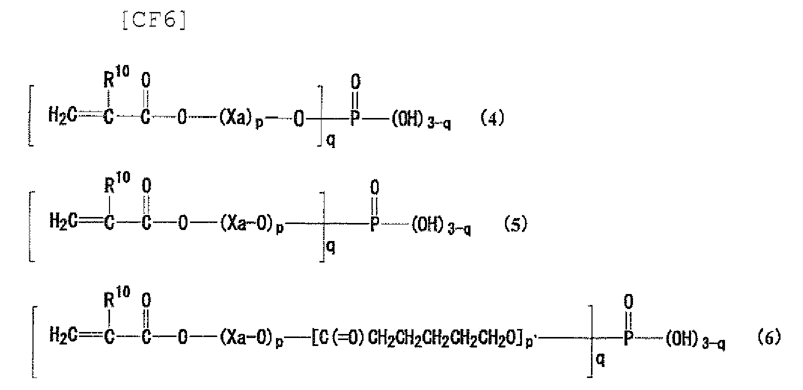

R¹⁰ in formulae (4), (5), and (6), is a hydrogen atom or methyl group. Xa is an alkylene or arylene group optionally having a substituent. p and p' are each independently an integer of 1 to 25. q is 1, 2, or 3.

The alkylene group of Xa preferably has 1 to 5 carbon atoms, and methylene, ethylene, propylene, and butylene groups are more preferred. The arylene group preferably has 6 to 10 carbon atoms, and the phenylene group is more preferred. Among them, the alkylene group is preferred in the present invention.
Examples of substituents of the alkylene group or arylene group of Xa include halogen atoms; hydroxyl groups; alkyl groups having generally 1 or more and generally 15 or less, preferably 10 or less of carbon atoms; alkenyl groups having the carbon number of 2-10; phenyl groups; carboxyl groups; sulfanyl groups; phosphino groups; amino groups; and nitro groups.
p and p' is generally 1 or more, and 10 or less, preferably 4 or less.

Specific examples of such compounds include (meth)acryloyloxyethyl phosphate, bis[(meth)acryloyloxyethyl]phosphate, and (meth)acryloyloxyethylene glycol phosphate. Examples of actual product names include "LIGHT-ESTER P-1M", "LIGHT-ESTER P-2M", "LIGHT-ACRYLATE P-1A", and "LIGHT-ACRYLATE P-2A" available from KYOEISHA CHEMICAL Co., LTD; and "KAYAMER PM-2" and "KAYAMER PM-21" available from Nippon Kayaku Co. Ltd. These compounds may be used alone or in any combination in any ratio.

Examples of the urethane (meth)acrylates from hydroxy (meth)acrylate compounds and polyisocyanate compounds include reaction products of hydroxy (meth)acrylate compounds, such as hydroxymethyl (meth)acrylate, hydroxyethyl (meth)acrylate, and tetramethylolethane tri(meth)acrylate, with polyisocyanate compounds, such as aliphatic polyisocyanates, e.g., hexamethylene diisocyanate, and 1,8-diisocyanato-4-isocyanatomethyloctane; alicyclic polyisocyanates, e.g., cyclohexane diisocyanate, dimethylcyclohexane diisocyanate, 4,4-methylenebis(cyclohexylisocyanate), isophorone diisocyanate, and bicycloheptane triisocyanate; aromatic polyisocyanates, e.g., 4,4-diphenylmethane diisocyanate, and tris(isocyanatophenyl) thiophosphate; and heterocyclic polyisocyanates, e.g., isocyanurate.
Available examples of such compounds include "U-4HA", "UA-306A", and "U6LPA" made by SHIN-NAKAMURA CHEMICAL CO., LTD.

Among them, preferred compounds have 4 or more urethane bonds [-NH-CO-O-] and 4 or more (meth)acryloyloxy groups per molecule. Such compounds can be prepared by the reaction of, for example, compounds (i) having generally 4 or more, preferably 6 or more isocyanate groups per molecule with compounds (ii) having 1 or more hydroxyl group and generally 2 or more, preferably 3 or more (meth)acryloyloxy groups per molecule.
Examples of compounds (i) include compounds (i-1) prepared by the reaction of compounds having 4 or more hydroxyl groups per molecule, e.g., pentaerythritol and polyglycerol with diisocyanate compounds such as hexamethylene diisocyanate, trimethylhexamethylene diisocyanate, isophorone diisocyanate, and tolylene diisocyanate; compounds (i-2) prepared by the reaction of compounds having 2 or more hydroxyl groups per molecule, e.g., ethylene glycol with compounds having 3 or more isocyanate groups per molecule, such as biuret-type compounds, e.g., "Duranate 24A-100", "Duranate 22A-75PX", "Duranate 21S-75E", and "Duranate 18H-70B", and adduct-type compounds, e.g., "Duranate P-301-75E", "Duranate E-402-90T", and "Duranate E-405-80T", these are available from Asahi Kasei Corporation; and compounds (i-3) prepared by polymerization or copolymerization of, for example, isocynatoethyl (meth)acrylate. A specific product is, for example, "Duranate Me20-100" available from Asahi Kasei Corporation.
Examples of compounds (ii) include pentaerythritol di(meth)acrylate, dipentaerythritol tri(meth)acrylate, dipentaerythritol tetra(meth)acrylate, and dipentaerythritol penta(meth)acrylate.

Examples of epoxy (meth)acrylates by the reaction of (meth)acrylic acid or hydroxy (meth)acrylate compounds with polyepoxy compounds include reaction products of (meth)acrylic acid or the hydroxy (meth)acrylate compounds described above with polyepoxy compounds such as aliphatic polyepoxy compounds, e.g., (poly)ethylene glycol polyglycidyl ether, (poly)propylene glycol polyglycidyl ether, (poly)tetramethylene glycol polyglycidyl ether, (poly)pentamethylene glycol polyglycidyl ether, (poly)neopentylglycol polyglycidyl ether, (poly)hexamethylene glycol polyglycidyl ether, (poly)trimethylolpropane polyglycidyl ether, (poly)glycerol polyglycidyl ether, and (paly)sorbitol polyglycidyl ether; aromatic polyepoxy compounds, e.g., phenol novolak polyepoxy compounds, brominated phenol novolak polyepoxy compounds, (o-,m-,p-)cresol novolak polyepoxy compounds, bisphenol A polyepoxy compounds, and bisphenol F polyepoxy compounds; and heterocyclic polyepoxy compounds, e.g., sorbitan polyglycidyl ether, triglycidyl isocyanurate, and triglycidyltris(2-hydroxyethyl) isocyanurate.

Examples of other ethylenically unsaturated compounds include (meth)acrylamides such as ethylenebis(meth)acrylamide; allyl esters such as diallyl phthalate; vinyl-containing compounds such as divinyl phthalate; and compounds containing thioether bonds exhibiting improved crosslinking rates prepared by conversion of ether bonds of ethylenically unsaturated compounds containing ether bonds into thioether bonds, in the presence of, for example, phosphorus pentasulfide. Further examples include compounds that are bound by the reaction of ethylenically unsaturated compounds with silica sol using silane coupling agents and that exhibit improved strength and heat resistance after curing, for example, disclosed in Japanese Unexamined Patent Application Publication Nos. 5-287215 and 9-100111, compounds bound by the reaction of polyfunctional (meth)acrylate compounds with silica sol having a particle size of 5 to 30 nm [e.g., isopropanol-dispersed organosilica sol ("IPA-ST" available from Nissan Chemical Industries, Ltd.), methyl ethyl ketone-dispersed organosilica sol ("MEK-ST" available from Nissan Chemical Industries, Ltd.), and methyl isobutyl ketone-dispersed organosilica sol ("MIBK-ST" available from Nissan Chemical Industries, Ltd.)] using silane coupling agents containing isocyanate groups or mercapto groups.

In the present invention, preferred ethylenically unsaturated compounds are esters of unsaturated carboxylic acids and polyhydroxy compounds or urethane (meth)acrylates, and more preferred are compounds having penta or higher functionality, such as dipentaerythritol hexa(meth)acrylate, and dipentaerythritol penta(meth)acrylate.

These ethylenically unsaturated compounds may be used alone or in any combination in any proportion.
The proportion of the ethylenically unsaturated compound on the basis of the total solid content in the light-blocking photosensitive resin composition of the present invention is generally 1 wt% or more, preferably 4 wt% or more and generally 20 wt% or less, preferably 18 wt% or less. A larger proportion of ethylenically unsaturated compound readily leads to a bored bottom shape, whereas a smaller proportion may lead to insufficient sensitivity.

### [4] Light-blocking component

The light-blocking photosensitive resin composition of the present invention contains a light-blocking component.
The light-blocking component is a component having absorption in the visible light wavelength region and thus having a light-blocking function and is called coloring agent. Examples of coloring agents used as light-blocking components in the present invention include organic pigments, inorganic pigments, and dyes. Examples of inorganic pigments include carbon black and titanium oxide. Examples of dyes include azo, anthraquinone, phthalocyanine, quinoneimine, quinoline, nitro, carbonyl, and methyne dyes. The organic pigments will be described below in detail. The light-blocking components may be used alone or in any combination in any proportion.

In the light-blocking photosensitive resin composition of the present invention, the content of the light-blocking component on the basis of the total solid content in the composition is generally 35 wt% or more, preferably 36 wt% or more, more preferably 37 wt% or more, and generally 70 wt% or less, preferably 65 wt% or less, and more preferably 60 wt% or less. A lower content than the lower limit of the range may not ensure sufficient light-blocking ability as a resin black matrix, and may lead to a smaller contact angle with a substrate. On the other hand, a content exceeding the upper limit of the range may make development and formation of images difficult.

In the present invention, 95% or more of the light-blocking component is preferably organic pigment. More preferably 96% or more, particulary preferably 97% or more is organic pigment.
In the light-blocking photosensitive resin composition of the present invention, the content of the light-blocking component other than organic pigment is preferably less than 5%. For example, a higher dye content may have a disadvantage in sensitivity. When inorganic pigments such as carbon black and titanium oxide are further contained, these exhibit absorption in the near infrared region in the wavelength range of 850 nm to 3000 nm, despite being easy to ensure light-blocking ability. A resin black matrix that is formed on a TFT element substrate using light-blocking photosensitive resin composition of the present invention may not dissipate heat emerging from the TFT elements, resulting malfunction. Since these inorganic pigments tends to decrease the volume resistivity and increase the dielectric constant, a resin black matrix formed on a TFT element substrate may lead to short-circuiting of electrical circuits and irregular response of liquid crystal. The inorganic pigments should be used so as not to adversely affect the light transmittance, volume resistivity, and dielectric constant of the resin black matrix formed using a light-blocking photosensitive resin composition of the present invention, and in an amount of, for example, less than 5%, preferably less than 4%, more preferably less than 3% of the light-blocking component.

Organic pigments used as a primary light-blocking component in the light-blocking photosensitive resin composition of the present invention will be described below.
Organic pigments used in the present invention are not limited to black pigments and may be mixtures of, for example, blue pigments, green pigments, red pigments, yellow pigments, violet pigments, orange pigments, and brown pigments. Such mixtures can preferably have light-blocking ability and controlled color tone.
The types of the organic pigments are, for example, azo, phthalocyanine, quinacridone, benzimidazolone, isoindolinone, dioxazine, indanthrene, and perylene types.
Examples of pigments used in the present invention are represented by pigment numbers. Hereafter, for example, the term "C.I. Pigment Red 2" indicates color index (C.I.).

Examples of red pigments include C.I. Pigment Reds 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276. Among them, preferred are C.I. Pigment Reds 48:1, 122, 168, 177, 202, 206, 207, 209, 224, 242, and 254, and more preferred are C.I. Pigment Reds 177, 209, 224, and 254.

Examples of blue pigments include C.I. Pigment Blues 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79. Among them, preferred are C.I. Pigment Blues 15, 15:1, 15:2, 15:3, 15:4, and 15:6, more preferred is C.I. Pigment Blue 15:6.

Examples of green pigments include C.I. Pigment Greens 1, 2, 4, 7, 8, 10, 13, 14, 15, 17, 18, 19, 26, 36, 45, 48, 50, 51, 54, and 55. Among them, preferred are C.I. Pigment Greens 7 and 36.

Examples of yellow pigments include C.I. Pigment Yellows 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208. Among them, preferred are C.I. Pigment Yellows 83, 117, 129, 138, 139, 150, 154, 155, 180, and 185, more preferred are C.I. Pigment Yellows 83, 138, 139, 150, and 180.

Examples of orange pigments include C.I. Pigment Oranges 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among them, preferred are C.I. Pigment Oranges 38 and 71.

Examples of violet pigments include C.I. Pigment Violets 1, 1:1, 2, 2:2, 3, 3:1, 3:3, 5, 5:1, 14, 15, 16, 19, 23, 25, 27, 29, 31, 32, 37, 39, 42, 44, 47, 49, and 50. Among them, preferred are C.I. Pigment Violets 19 and 23, and more preferred is C.I. Pigment Violet 23.

Several organic pigments are selected and used usually in combination of the organic pigments described above, as a primary light-blocking component of the light-blocking photosensitive resin composition of the present invention. Organic pigments used and combination thereof can be appropriately determined such that the resin black matrix formed of the composition of the present invention has desirable light transmittance, volume resistivity, and relative permittivity.

The light transmittance of the resulting resin black matrix is primarily determined by the combination of light transmittances of organic pigments, although it depends on the components in the composition and the reaction products after film formation. The combination of organic pigments can be determined through simulation of light transmittance by convolution of spectra of the organic pigments from the proportion in the mixture and confirmation of designed light transmission in an intended wavelength region. More specifically, for example, in a combination of multiple organic pigments having absorption (not transmitting light) in different narrow regions in the wavelength range of 400 nm to 700 nm, a first organic pigment having a maximum absorption wavelength in the range of 400 nm to 500 nm, a second organic pigment having a maximum absorption wavelength in the range of 500 nm to 600 nm, and a third organic pigment having a maximum absorption wavelength in the range of 600 nm to 800 nm may be mixed in a predetermined proportion in view of absorbances thereof. Thereby a combination of organic pigments used in a composition for forming a resin black matrix that can absorb light over the entire wavelength range of 400 nm to 700 nm (has light-blocking ability) can be determined. After the types and amounts of the organic pigments are determined, the composition can be determined in view of light transmittance of the entire composition containing other components.

Such a combination of organic pigments is advantageous in that it can also control chromaticity, unlike use of a single light-blocking component having high light-blocking ability over the entire visible light wavelength region such as carbon black. On the other hand, such a combination of multiple organic pigments readily leads to nonuniform light transmittance. Accordingly, it is preferred that organic pigments be appropriately selected in the light-blocking photosensitive resin composition of the present invention such that the standard deviation of light transmittances of the composition is 0.1% or less in the wavelength range of 400 nm to 700 nm. This can constantly provide a resin black matrix having uniform and high light-blocking ability over the entire wavelength range.

The light transmittance of the composition can be determined as follows: A prepared light-blocking photosensitive resin composition is diluted in a solvent (for example propylene glycol monomethyl ether acetate (PGMEA)) such that the total solid content is, for example, 500 ppm or less, and an analytical sample is thus prepared, and the analytical sample is subjected to spectrophotometric analysis using the dilution solvent as a reference. The calculation of the standard deviation of light transmittances of the composition is the same as the calculation of the standard deviation of light transmittances of the resin black matrix described above.

Preferably, a combination of organic pigments selected from at least three following groups of the groups (a) to (f) is used such that the standard deviation of light transmittances of the composition is 0.1% or less over the wavelength range of 400 nm, to 700 nm.
(a) Red pigment selected from C.I. Pigment Reds 177, 209, 224, and 254.
(b) Blue pigment being C.I. Pigment Blue 15:6.
(c) Green pigments selected from C.I. Pigment Greens 7 and 36.
(d) Yellow pigment selected from C.I. Pigment Yellows 83, 138, 139, 150, and 180.
(e) Violet pigment being C.I. Pigment Violet 23.
(f) Orange pigment selected from C.I. Pigment Oranges 38 and 71.

The number of the selected organic pigments may be appropriately determined such that the light-blocking photosensitive resin composition of the present invention prepared using the organic pigment satisfies the intended standard deviation of light transmittances, and three, preferably four, more preferably five of these groups are used in combination. Among at least three of groups (a) to (f), a plurality of organic pigments may be selected in each group.

Specific examples of combination of the organic pigments include, but not limited to, a combination of Pigment Red 254/Pigment Green 36/Pigment Yellow 150/pigment Blue 15:6/Pigment Violet 23, a combination of Pigment Red 177/Pigment Green 36/pigment Yellow 138/Pigment Blue 15:6/Pigment Violet 23, a combination of Pigment Red 149/Pigment Green 36/pigment Yellow 139/Pigment Blue 15:6/Pigment Violet 23, and a combination of Pigment Yellow 150/pigment Blue 15:6/Pigment Violet 23, and a combination of Pigment Red 254/pigment Green 36/Pigment Blue 15:6.

The organic pigments are preferably prepared by dispersion treatment of primary particles of pigments such that the average particle diameter is generally 1 µm or less, preferably 0.5 µm or less, more preferably 0.25 µm or less. The average particle diameter is so-called average particle diameter of dispersed particles that is determined based on a particle diameter measured by any known method, for example, a dynamic light scattering (DLS) method. The measurement of the particle diameter is carried out at 25°C using throughly diluted pigment dispersion.

The organic pigments are generally dispersed in a solvent prior to mixing with the light-blocking photosensitive resin composition of the present invention. As described above, inorganic pigments can also be used in the light-blocking photosensitive resin composition of the present invention, and are also mixed as described above.
In dispersion of these pigments in a solvent, use of pigment dispersant and/or dispersing aid is preferred to improve dispersion and stability of dispersion. Also, the use of the alkali-soluble resin described above is preferred (hereinafter, the alkali-soluble resin used for improving dispersion stability during the dispersion operation may be referred to as "dispersion resin").

Among them, use of polymeric dispersants as pigment dispersant is preferred because it ensures high long-term dispersion stability. Examples of polymeric dispersants include urethane dispersants, polyethyleneimine dispersants, polyoxyethylene alkyl ether dispersants, polyoxyethylene glycol diester dispersants, sorbitan aliphatic ester dispersants, and modified aliphatic polyester dispersants. Among them, dispersants comprising graft copolymers containing nitrogen atoms are particularly preferred for the light-blocking photosensitive resin composition containing large amounts of pigments of the present invention, in view of developing ability. Specific examples of the dispersants include EFKA (made by EFKA Additives B.V.), Disperbik (made by BYK-Chemie), DISPERON (made by Kusumoto Chemicals, Ltd.), SOLSPERSE (made by The Lubrizol Corporation), KP (made by Shin-Etsu Chemical Co., Ltd.), and POLYFLOW (made by KYOEISHA CHEMICAL Co., LTD), all of these being commercial names. These dispersants may be used alone or in any combination in any proportion.

Examples of the usable dispersing aids include pigment derivatives. Examples of pigment derivatives include azo, phthalocyanine, quinacridone, benzimidazolone, quinophthalone, isoindolinone, dioxazine, anthraquinone, indanthrene, perylene, perinone, diketopyrrolopyrrole, and dioxazine (sic) derivatives. Among them preferred are quinophthalone derivatives. Examples of substituents of the pigment derivatives include sulfonate group, sulfonamido group and quaternary salts thereof, phthalimidomethyl groups, dialkylaminoalkyl groups, hydroxyl group, carboxyl group, amido group, which are bonded to the pigment skeleton directly or via alkyl group, aryl group, or heterocyclic group. Among them, preferred is sulfonate group. A plurality of substituents may be bonded on a single pigment skeleton. Examples of pigment derivatives include sulfonate derivatives of phthalocyanine, quinophthalone, anthraquinone, quinacridone, diketopyrrolopyrrole, and dioxazine. These dispersing aids and pigment derivatives may be used alone or in any combination in any proportion.

The content of the pigment dispersant and/or dispersing aid on the basis of the total solid content in the light-blocking photosensitive resin composition is generally 1 wt% or more, preferably 2 wt% or more and generally 30 wt% or less, preferably 25 wt% or less.
The content of the dispersing aid on the basis of the pigment is generally 0.1 wt% or more and generally 30 wt% or less, preferably 20 wt% or less, more preferably 10 wt% or less, still more preferably 5 wt% or less.

### [5] Other components

The light-blocking photosensitive resin composition of the present invention may further contain other components such as polymerization accelerators, sensitizing dyes, surfactants, photoacid generators, crosslinking agents, adhesion improvers, plasticizers, storage stabilizers, surface protectors, organic carboxylic acids, organic carboxylic anhydrides, development improvers, and thermal polymerization inhibitors, in addition to the components described above. These other components may be used alone or in any combination in any proportion.

### [5-1] Photoacid generator

Photoacid generator refers to compounds that can generate acids by ultraviolet rays. The contained photo-acid generator accelerates crosslinking reaction by the effect of acid generated by light exposure in the presence of a crosslinking agent such as a melamine compound. Among the photo-acid generators, preferred are photo-acid generator having high solubility, particularly, in a solvent. Examples of such compounds include, but not limited to, diaryliodoniums such as diphenyliodonium, ditolyliodonium, phenyl(p-anisyl)iodonium, bis(m-nitrophenyl)iodonium, bis(p-tert-butylphenyl)iodonium, bis(p-chlorophenyl)iodonium, bis(n-dodecyl)iodonium, p-isobutylphenyl(p-tolyl)iodonium, and p-isopropylphenyl(p-tolyl)iodonium; chlorides, bromides, or borofluorides, hexafluorophosphates, hexafluoroarsenates, aromatic sulfonates, and tetrakis(pentafluorophenyl)borates of triarylsulfoniums such as triphenylsulfonium; sulfonium organic boron complexes such as diphenylphenacylsulfonium (n-butyl) triphenyl borate; and triazine compounds such as 2-methyl-4,6-bistrichloromethyltriazine and 2-(4-methoxyphenyl)-4,6-bistrichloromethyltriazine. The photo-acid generator may be used alone or in any combination in any proportion.

### [5-2] Crosslinking agent

The light-blocking photosensitive resin composition of the present invention may further contain crosslinking agents. The crosslinking agents are, for example, melamine and guanamine compounds. Examples of these crosslinking agents include melamine and guanamine compounds represented by the following formula (7). Other examples are melamine or guanamine resins prepared by polycondensation of these melamine or guanamine compounds with formaldehyde, and modified resins prepared by alcohol condensation of methylol groups of these resins.

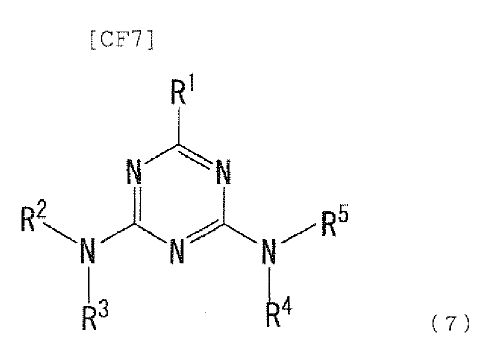

In formula (7), R¹ represents -NR⁶R⁷ or aryl group. When R¹ is -NR⁶R⁷, one of R², R³, R⁴, R⁵, R⁶, and R⁷ represents -CH₂OR⁸. When R¹ is aryl group, one of R², R³, R⁴, and R⁵ represents -CH₂OR⁸. The remaining R², R³, R⁴, R⁵, R⁶, and R⁷ independently represent hydrogen atom or -CH₂OR⁸. R⁸ represents hydrogen atom or alkyl group.

The aryl group is generally phenyl group, 1-naphthyl group or 2-naphthyl group. For example, a substituent group, e.g., alkyl group, alkoxy group, or halogen atom may be bonded to the phenyl group or naphthyl group. The alkyl group and alkoxy group each have generally 1 to 6 carbon atoms. Among the alkyl groups represented by R⁸, preferred are methyl group and ethyl group, more preferred is methyl group.

The melamine compounds represented by the formula (7), in which R¹ is -NR⁶R⁷, include, hexamethylolmelamine, pentamethylolmelamine, tetramethylolmelamine, hexamethoxymethylmelamine, pentamethoxymethylmelamine, tetramethoxymethylmelamine, and hexaethoxymethylmelamine, for example.

The guanamine compounds represented by the formula (7), in which R¹ is aryl group, include tetramethylolbenzoguanamine, tetramethoxymethylbenzoguanamine, trimethoxymethylbenzoguanamine, and tetraethoxymethylbenzoguanamine, for example.

Another type of crosslinking agent used in the light-blocking photosensitive resin composition of the present invention is a crosslinking agent having a methylol or methylolalkyl ether group. Examples of such a compound include 2,6-bis(hydroxymethyl)-4-methylphenol, 4-tert-butyl-2,6-bis(hydroxymethyl)phenol, 5-ethyl-1,3-bis (hydroxymethyl)perhydro-1,3,5-triazin-2-one (commonly know as N-ethyldimethyloltriazone) and its dimethyl ether, dimethyloltrimethyleneurea and its dimethyl ether, 3,5-bis(hydroxymethyl)perhydro-1,3,5-oxadiazin-4-one (commonly known as dimethylolurone) and its dimethyl ether, and tetramethylolglyoxazaldiurein and its tetramethyl ether.

These crosslinking agents may be used alone or in any combination in any proportion.
The amount of crosslinking agent on the basis of the total solid content in the light-blocking photosensitive resin composition is generally 0.1 parts by weight or more, preferably 0.5 parts by weight or more, and generally 15 parts by weight or less, preferably 10 parts by weight or less.

### [5-3] Adhesion improver

The light-blocking photosensitive resin composition of the present invention may contain adhesion improvers so that thin lines and dots sufficiently adhere to a substrate.
Examples of the adhesion improvers include compounds containing nitrogen atoms, compound containing phosphate groups, and silane coupling agents.
Examples of preferred compounds containing nitrogen atoms include diamines (including adhesion enhancers disclosed in Japanese Unexamined Patent Application Publication No. 11-184080) and azoles. Among them preferred are azoles, and particularly preferred are imidazoles (including adhesion improvers disclosed in Japanese Unexamined Patent Application Publication No. 9-236923), benzimidazoles, and benzotriazoles (including adhesion improvers disclosed in Japanese Unexamined Patent Application Publication No. 2000-171968). Among them, particularly preferred are imidazoles and benzimidazoles. Among them, in view of a significant improvement in adhesion, preferred are 2-hydroxybenzimidazole, 2-hydroxyethylbenzimidazole, benzimidazole, 2-hydroxyimidazole, imidazole, 2-mercaptoimidazole, and 2-aminoimidazole, and particularly preferred are 2-hydroxybenzimidazole, benzimidazole, 2-hydroxyimidazole, and imidazole.
A variety of silane coupling agents including epoxy, methacryl, and amino silane coupling agents can be used, and epoxy silane coupling agents are preferred.
Examples of the phosphate-containing compounds include the phosphates containing (meth)acryloyloxy groups described above.

The adhesion improvers may be used alone or in any combination in any proportion.
The content of the adhesion improver depends on the type of the adhesion improver used, and is generally 0.01 wt% or more, preferably 0.05 wt% or more, and generally 5 wt% or less, preferably 3 wt% or less on the basis of the total solid content in the light-blocking photosensitive resin composition.

### [5-4] Sensitizing dye

Examples of the sensitizing dyes include xanthene dyes disclosed in Japanese Unexamined Patent Application Publication Nos. 4-221958 and 4-219756, coumarin dyes having heterocycles disclosed in Japanese Unexamined Patent Application Publication Nos. 3-239703 and 5-289335, 3-ketocoumarine compounds disclosed in Japanese Unexamined Patent Application Publication Nos. 3-239703 and 5-289335, pyrromethene dyes disclosed in Japanese Unexamined Patent Application Publication No. 6-19240, and dyes having dialkylaminobenzene skelton disclosed in Japanese Unexamined Patent Application Publication Nos. 47-2528 and 54-155292, Japanese Examined Patent Application Publication No. 45-37377, and Japanese Unexamined Patent Application Publication Nos. 48-84183, 52-112681, 58-15503, 60-88005, 59-56403, 2-69, 57-168088, 5-107761, 5-210240, and 4-288818.

The sensitizing dyes may be used alone or in any combination in any proportion.
The content of the sensitizing dye on the basis of the total solid content in the light-blocking photosensitive resin composition is generally 0.01 wt% or more, preferably 0.05 wt% or more, and generally 5 wt% or less, preferably 3 wt% or less. A lower content may lead to insufficient sensitization, whereas a larger content may lead to poor developing ability.

### [5-5] Surfactant

Examples of usable surfactants include a variety of surfactants such as anionic, cationic, nonionic, and ampholytic surfactants. Among them, preferably used are nonionic surfactants, which would be less likely to affect various properties adversely. In particular, fluorinated or silicon surfactants are effective in coating characteristics.

The surfactants may be used alone or in any combination in any proportion.
The proportion of the surfactant on the basis of the total solid content in the light-blocking photosensitive resin composition is generally 0.001 wt% or more, preferably 0.005 wt% or more, more preferably 0.01 wt% or more, particulary preferably 0.03 wt% or more, and generally 10 wt% or less, preferably 1 wt% or more (sic), more preferably 0.5 wt% or more (sic), particulary preferably 0.3 wt% or more (sic).

### [5-6] Organic carboxylic acid and organic carboxylic anhydride

The light-blocking photosensitive resin composition of the present invention may contain organic carboxylic acids and/or organic carboxylic acid anhydrides to improve developing ability and to prevent scumming. Examples of organic carboxylic acids include aliphatic carboxylic acids and/or aromatic carboxylic acids. Examples of aliphatic carboxylic acids include monocarboxylic acids such as formic acid, acetic acid, propionic acid, butyric acid, valeric acid, pivalic acid, caproic acid, diethylacetic acid, enanthic acid, caprylic acid, glycolic acid, acrylic acid, and methacrylic acid; dicarboxylic acids such as oxalic acid, malonic acid, succinic acid, glutaric acid, adipic acid, pimelic acid, suberic acid, azelaic acid, sebacic acid, brassylic acid, methylmalonic acid, ethylmalonic acid, dimethylmalonic acid, methylsuccinic acid, tetramethylsuccinic acid, cyclohexanedicarboxylic acid, cyclohexenedicarboxylic acid, itaconic acid, citraconic acid, maleic acid, and fumaric acid; tricarboxylic acids such as tricarballylic acid, aconitic acid, and camphoronic acid. Examples of aromatic carboxylic acids include carboxylic acids in which carboxyl groups are directly bonded to the phenyl groups and carboxylic acids in which carboxyl groups are bonded to the phenyl groups via carbon bonds, such as benzoic acid, toluic acid, cuminic acid, hemellitic acid, mesitylenic acid, phthalic acid, phthalic acid (sic), isophthalic acid, terephthalic acid, trimellitic acid, trimesic acid, mellophanic acid, pyromellitic acid, phenylacetic acid, hydratropic acid, hydrocinnamic acid, mandelic acid, phenylsuccinic acid, atropic acid, cinnamic acid, methyl cinnamate, benzyl cinnamate, cinnamylideneacetic acid, coumalic acid, and umbellic acid.

Among the organic carboxylic acids, preferred are monocarboxylic acids and dicarboxylic acids, more preferred are malonic acid, glutaric acid, and glycolic acid, and particulary preferred is malonic acid.
The molecular weight of the organic carboxylic acid is generally 1000 or less and generally 50 or more. A larger molecular weight of the organic carboxylic acid may cause insufficiently inhibited scumming, whereas a smaller molecular weight may cause a reduced acid content or process contamination due to sublimation or vaporization.

Examples of organic carboxylic anhydrides include aliphatic carboxylic anhydrides and/or aromatic carboxylic anhydrides. Examples of the aliphatic carboxylic anhydrides include acetic anhydride, trichloroacetic anhydride, trifluoroacetic anhydride, tetrahydrophthalic anhydride, succinic anhydride, maleic anhydride, itaconic anhydride, citraconic anhydride, glutaric anhydride, 1,2-cyclohexenedicarboxylic anhydride, n-octadecylsuccinic anhydride, and 5-norbornene-2,3-dicarboxylic anhydride. Examples of aromatic carboxylic anhydrides include phthalic anhydride, trimellitic anhydride, pyromellitic anhydride, and naphthalic anhydride.

Among them organic carboxylic anhydrides, preferred are maleic anhydride, succinic anhydride, itaconic anhydride, and citraconic anhydride, more preferred is maleic anhydride.
The molecular weight of the organic carboxylic anhydride is generally 800 or less, preferably 600 or less, more preferably 500 or less, and generally 50 or more. A larger molecular weight of the organic carboxylic anhydride may cause insufficiently inhibited scumming, whereas a smaller molecular weight may cause a reduced acid content or process contamination due to sublimation or vaporization.

These organic carboxylic acids and organic carboxylic anhydrides may be used alone or in any combination in any proportion.
The content of the organic carboxylic acid and organic carboxylic anhydride on the basis of the total solid content in the light-blocking photosensitive resin composition of the present invention is generally 0.01 wt% or more, preferably 0.03 wt% or more, and generally 5 wt% or less, preferably 3 wt% or less. A smaller content may cause insufficient effect whereas a larger content may cause poor surface smoothness and sensitivity and may generate unsolved pieces.

### [5-7] Thermal polymerization inhibitors

Examples of thermal polymerization inhibitors include hydroquinone, p-methoxyphenol, pyrogallol, catechol, 2,6-t-butyl-p-cresol, and β-naphthol. The thermal polymerization inhibitors may be used alone or in any combination in any proportion.
The content of the thermal polymerization inhibitor on the basis of the total solid content in the light-blocking photosensitive resin composition preferably is 0 to 2 wt%.

### [5-8] Plasticizer

Examples of the plasticizers include dioctyl phthalate, didodecyl phthalate, triethylene glycol dicaprylate, dimethyl glycol phthalate, tricresyl phosphate, dioctyl adipate, dibutyl sebacate, and triacetyl glycerine. The plasticizers may be used alone or in any combination in any proportion.
The content of the plasticizer on the basis of the total solid content in the light-blocking photosensitive resin composition preferably is 5 wt% or less.

### [6] Solvent

Each component contained in the light-blocking photosensitive resin composition of the present invention is used after dissolution or dispersion in a solvent.

Examples of usable solvents include diisopropyl ether, mineral spirit, n-pentane, amyl ether, ethyl caprirate, n-hexane, diethyl ether, isoprene, ethyl isobutyl ether, butyl stearate, n-octane, Barsol 2, Apco 18 solvent, diisobutylene, amyl acetate, butyl acetate, Apco thinner, butyl ether, diisobutyl ketone, methylcyclohexene, methyl nonyl ketone, propyl ether, dodecane, Socal Solvents No. 1 and No. 2, amyl formate, dihexyl ether, diisopropyl ketone, Solvesso 150, (n,sec,t-)butyl acetate, hexene, Shell TS28 solvent, butyl chloride, ethyl amyl ketone, ethyl benzoate, amyl chloride, ethylene glycol diethyl ether, ethyl orthaformate, methoxymethylpentanone, methyl butyl ketone, methyl hexyl ketone, methyl isobutyrate, benzonitrile, ethyl propionate, methyl cellosolve acetate, methyl isoamyl ketone, methyl isobutyl ketone, propyl acetate, amyl acetate, amyl formate, bicyclohexyl, diethylene glycol monoethyl ether acetate, dipentene, methoxymethylpentanol, methyl amyl ketone, methyl isopropyl ketone, propyl propionate, propylene glycol t-butyl ether, methyl ethyl ketone, methyl cellosolve, ethyl cellosolve, ethyl cellosolve acetate, carbitol, cyclohexanone, ethyl acetate, propylene glycol, propylene glycol monomethyl ether, propylene glycol monomethyl ether acetate, propylene glycol monoethyl ether, propylene glycol monoethyl ether acetate, dipropylene glycol monoethyl ether, dipropylene glycol dimethyl ether, dipropylene glycol monomethyl ether, dipropylene glycol monomethyl ether acetate, 3-methoxypropionic acid, 3-ethoxypropionic acid, methyl 3-ethoxypropionate, ethyl 3-ethoxypropionate, methyl 3-methoxypropionate, ethyl 3-methoxypropionate, propyl 3-methoxypropionate, butyl 3-methoxypropionate, diglyme, ethylene glycol acetate, ethyl carbitol, butyl carbitol, ethylene glycol monobutyl ether, propylene glycol t-butyl ether, 3-methoxybutanol, 3-methyl-3-methoxybutanol, tripropylene glycol methyl ether, 3-methoxybutyl acetate, and 3-methyl-3-methoxybutyl acetate.

These solvents may be used alone or in any combination in any proportion.
The content of the solvent in the light-blooking photosensitive resin composition of the present invention is generally 90 wt% or less, and generally 60 wt% or more, preferably 70 wt% or more in view of easier coating of a coating film and control of the thickness of the film.

### [Preparation of pigment dispersion liquid]

The organic pigment, which is to be contained as a light-blocking component in the light-blocking photosensitive resin composition of the present invention, is preferably prepared in the form of pigment dispersion liquid (ink) in advance, as described above. The inorganic pigment is also preferably prepared in a similar manner, and its dispersion liquid may further contain another light-blocking component within the proportion described above.

The pigment dispersion liquid can be prepared in a variety of manners, and one of the manners is described below.
Pigments, solvent, pigment dispersant, and/or dispersing aid are weighed according to a predetermined recipe, and the pigments are dispersed through a dispersion step to form pigment dispersion liquid. The dispersion step may be carried out, for example, using a paint conditioner, sand grinder, ball mill, roll mill, stone mill, jet mill, or homogenizer. Such a dispersion step enables the pigments to be milled into microparticles, and thus the light-blocking photosensitive resin composition containing the pigment dispersion exhibits improved coating characteristics.

The pigments may be dispersed together with the alkali-soluble resins or the pigment derivatives, which are described above, if necessary. For example, in dispersion treatment in a sand grinder, it is preferable to use glass or zirconia beads having a diameter of 0.1 to several millimeters. The dispersion temperature is set at generally 0°C or more, preferably room temperature or more, and generally 100°C or less, preferably 80°C or less. Since proper dispersion time depends on the composition of the pigment dispersion liquid (for example pigments, solvent, and dispersant), and the size of an apparatus of the sand grinder, it is preferable to adjust these parameters to adequate ranges.

### [Preparation of light-blocking photosensitive resin composition]

The pigment dispersion liquid (ink) prepared by the dispersion treatment is mixed with other components for the light-blocking photosensitive resin composition, and the mixture is homogenized to prepare a light-blocking photosensitive resin composition. Each component in the light-blocking photosensitive resin composition may be completely dissolved or may be homogeneously dispersed in the solvent. The composition is preferably passed through a filter in order to remove microdust, which may be incorporated during the manufacturing process.

### [Formation of resin black matrix]

The light-blocking photosensitive resin composition of the present invention is used for formation of the resin black matrix of the present invention, as follows.
The light-blocking photosensitive resin composition of the present invention can be applied onto any substrate, e.g., a transparent substrate and a TFT element substrate, for example, by a spinner, wire bar, flow coating, die coating, roll coating, or spray coating process. Among them, a die coating process is preferred in comprehensive view of use of a significantly reduced amount of coating liquid, no mist adhesion, which is inevitable in spin coating, and suppressed contamination by foreign materials.

After the substrate coated with the film is dried, a photomask is placed on the sample, and the film is exposed through the photomask and is developed. If necessary, through optional thermal curing or photocuring, a resin black matrix is formed. Preferably, the resin black matrix of the present invention is formed on the TFT element substrate, and its structure is not particularly limited in both COA and BOA types and can be applied to various systems.

The thickness of the dried film of the resin black matrix is generally 0.5 µm or more, preferably 1 µm or more, and generally 5 µm or less, preferably 4 µm (sic). A color filter provided with the resin black matrix of the present invention preferably has an optical density of 1.0 or more in view of light-blocking ability at a thickness thereof of 1 µm.

Drying may be carried out, for example, using a hot plate, IR oven, or convection oven. Preferred drying conditions include a temperature in the range of 40°C to 150°C and a time in the range of 10 seconds to 60 minutes. Examples of light sources used for exposure include lamp light sources such as a xenon lamp, halogen lamp, tungsten lamp, high-pressure mercury lamp, ultra-high-pressure mercury lamp, metal halide lamp, medium-pressure mercury lamp, low-pressure mercury lamp, carbon arc, and fluorescent lamp; and laser light sources such as an argon ion laser, YAG laser, excimer laser, nitrogen laser, helium-cadmium laser, and semiconductor laser. In cases of use of a specific wavelength of the emerging light, an optical filter may be used.

Development is carried out using a developing solution that can dissolve unexposed portions of the resist film. The developing solution used may be organic solvents such as acetone, methylene chloride, trichlene, and cyclohexanone. Since such organic solvents, however, have disadvantages of environmental pollution, toxicity to human bodies, and danger of fire, use of alkali developing solution free from such disadvantages is preferred.
Examples of such alkaline developing solutions include aqueous solutions containing inorganic alkaline agents such as sodium carbonate, potassium carbonate, sodium silicate, potassium silicate, sodium hydroxide, and potassium hydroxide or organic alkaline agents such as diethanolamine, triethanolamine, and tetraalkylammonium hydroxides. The alkaline developing solution may, if necessary, optionally contain a surfactant, a water-miscible organic solvent, and a low-molecular compound having a hydroxy or carboxyl group.

Among them, a surfactant is preferably contained in order to improve developing ability and image resolution and to suppress scumming. Examples of surfactants for developing solutions include anionic surfactants having sodium naphthalenesulfonate groups or sodium benzenesulfonate groups, nonionic surfactants having polyalkyleneoxy groups, and cationic surfactants having tetraalkylammonium groups.
The developing solutions and surfactants, water-miscible organic solvents, low-molecular weight compounds having hydroxyl groups or carboxyl groups to be contained in the developing solutions may be used alone or in any combination in any proportion respectively.
Development is not particularly limited and is carried out at a temperature of generally 15°C or more, preferably 20°C or more, and generally 40°C or less, preferably 30°C or less by a dipping, spraying, brushing, or ultrasonic process.

After development, the developing solution is washed out by water or the like, and the film is subjected to generally thermal curing or photocuring, preferably thermal curing.
Thermal curing is carried out at a temperature of generally 100°C or more, preferably 150°C or more, and generally 280°C or less, preferably 250°C or less for a time in the range of 5 to 60 minutes.

The resulting resin black matrix has a bottom width of generally 3 µm or more, preferably 5 µm or more, and generally 50 µm or less, preferably 30 µm or less. Its height is generally 0.5 µm or more, preferably 1 µm or more and generally 5 µm or less, preferably 4 µm or less. In addition, the angle to the substrate plane is generally 20° or more, preferably 40° or more, and generally 100° or less, preferably 90° or less. It is preferred that the volume resistivity is 1×10¹³ Ω·cm or more, and the dielectric constant is 5 or less. The average light transmittance is generally 60% or more and the minimum light transmittance is preferably 60% or more, over the wavelength range of 850 nm to 3000 nm. Even when the resin black matrix having such desired characteristics is formed on a TFT element substrate, it improves problems by internal heat accumulation in the device due to heat generation of the TFT element, which is observed in conventional resin black matrix.

### <3. TFT element substrate>

The resin black matrix of the present invention is preferably formed on a TFT element substrate.
The TFT element substrate may be produced by any known process disclosed, for example, in Japanese Unexamined Patent Application Publication Nos. 6-242433 and 7-175088.
The resin black matrix of the present invention is formed, by the above-mentioned method of forming the resin black matrix, on the TFT element substrate prepared by such a known process.

### <4. Liquid crystal display device>

The liquid crystal display device having the resin black matrix of the present invention may be produced by any known process, for example, disclosed in Japanese Unexamined Patent Application Publication Nos. 4-253028, 7-159772, and 9-311348.
The resin black matrix of the present invention is particulary preferably applied to BOA-type liquid crystal display devices described in Willem Den Boer, "Active Matrix Liquid Crystal Displays" (Newnes, 2005, pp. 141-142), and COA-type liquid crystal display devices disclosed in Japanese Unexamined Patent Application Publication Nos. 10-206888 and 2002-277899. The resin black matrix of the present invention exhibits high heat dissipation, excellent volume resistivity, and excellent dielectric constant, in addition to high light-blocking ability. Even when it is formed on a TFT element substrate of a COA- or BOA-type liquid crystal display device, it does not cause malfunction of the TFT element substrate, resulting in highly reliable production of the liquid crystal display device.

### Examples

The present invention will now be described in more detail by way of Manufacturing Examples, Examples and Comparative Examples. The present invention is, however, not limited to these examples without departing from the gist. In the following examples, the term "part(s)" refers to "part(s) by weight".

### <Synthesis of Alkali-soluble resin 1>

In a reactor were put 300 parts of XD1000 made by Nippon Kayaku Co., Ltd (polyglycidyl ether of dicyclopentadiene-phenol polymer, weight average molecular weight: 700, epoxy equivalent: 252), 87 parts of acrylic acid, 0.2 part of p-methoxyphenol, 5 parts of triphenylphosphine, and 255 parts of propylene glycol monomethyl ether acetate. The mixture was stirred until the acid value reached 3.0 mg-KOH/g at 100°C. It took 9 hours until the acid value reached the goal (acid value: 2.5). Next, 145 parts of tetrahydrophthalic anhydride was added to be reacted with the mixture for 4 hours at 120°C. A solution of Alkali-soluble resin 1 having an acid value of 100 and a polystyrene-equivalent weight average molecular weight of 2600 measured by GPC was prepared.

### <Synthesis of Alkali-soluble resin 2>

First, 120 parts of meta-cresol novolak resin having a weight average molecular weight of 4000 and 71 parts of glycidyl methacrylate were dissolved in 191 parts of propylene glycol monomethyl ether acetate. Next, 0.19 parts of para-methoxyphenol and 1.9 parts of tetraethylammonium chloride were added to be reacted with the mixture for 13 hours at 90°C. After it was confirmed that the remaining amount of the glycidyl methacrylate became 1% or less of the added amount by gas chromatography analysis, 45.6 parts of tetrahydrophthalic anhydride and 45.6 parts of propylene glycol monomethyl ether acetate were added to be reacted with the mixture for further 5 hours at 95°C. A solution of Alkali-soluble resin 2 was prepared after confirmation of no acid anhydride by infrared absorption (IR) analysis.

### <Synthesis of Alkali-soluble resin 3>

First, 145 parts of propylene glycol monomethyl ether acetate was stirred under a nitrogen gas substitution in a reactor while the temperature was raised to 120°C. To the system, 20 parts of styrene, 57 parts of glycidyl methacrylate, and 82 parts of monoacrylate having a tricyclodecane skeleton ("FA-513M" made by Hitachi Chemical Co., Ltd.) were added dropwise, and the mixture was stirred for 2 hours at 120°C.

Subsequently, the reactor was purged with air, and 27.0 parts of acrylic acid, 0.7 parts of tris(dimethylaminomethyl)phenol, and 0.12 parts of hydroquinone were added to continue the reaction for 6 hours at 120°C. Then, 52.0 parts of tetrahydrophthalic anhydride (THPA) and 0.7 parts of triethylamine were added for the reaction for 3.5 hours at 120°C to prepare an Alkali-soluble resin 3 solution. Alkali-soluble resin 3 having a polystyrene-equivalent weight average molecular weight of about 15000 measured by GPC was prepared.

### <Alkali-soluble resin 4>

"ZCR-1569H" (weight average molecular weight (Mw): 4000 to 5000, acid value: 100 mg-KOH/g) made by Nippon Kayaku Co., Ltd was used as Alkali-soluble resin 4.

### <Synthesis of Dispersant 1>

50 Parts by weight of polyethylene imine having a weight average molecular weight of about 5000 and 40 parts by weight of polycaprolactone (composed mostly of pentamer) were mixed with 300 parts by weight of propylene glycol monomethyl ether acetate, and the mixture was stirred for 3 hours at 150°C under nitrogen atmosphere. Synthesized dispersant 1 had a weight average molecular weight of 9000 measured by GPC.

### <Dispersant 2>

"Disperbyk-161" made by BYK-Chemie GmbH was used as a dispersant 2.

### <Photopolymerization initiator 1>

The compound shown in Formula (8) was synthesized by the method described in Japanese Unexamined Patent Application Publication No. 2006-36750. This was used as Photopolymerization initiator 1.

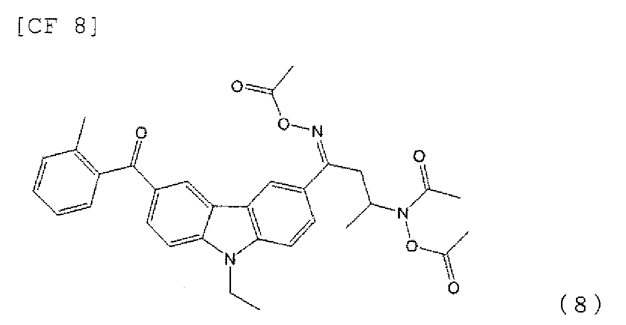

### <Preparations of pigment dispersion liquids 1 to 6>

As shown in Table 1, each light-blocking component, dispersant, dispersion aid (S12000 made by The Lubrizol Corporation), Alkali-soluble resin, and propylene glycol monomethyl ether acetate (PGMEA) as a solvent were mixed in weight ratios shown in Table 1. After mixing, each mixture was put in a stainless steel container together with zirconia beads (average grain diameter: 0.5 mm) in an amount of three times by weight on the bases of the total weight, followed by six-hour dispersion in a paint shaker. Pigment dispersion liquids 1 to 6 were prepared.

[Table 1]

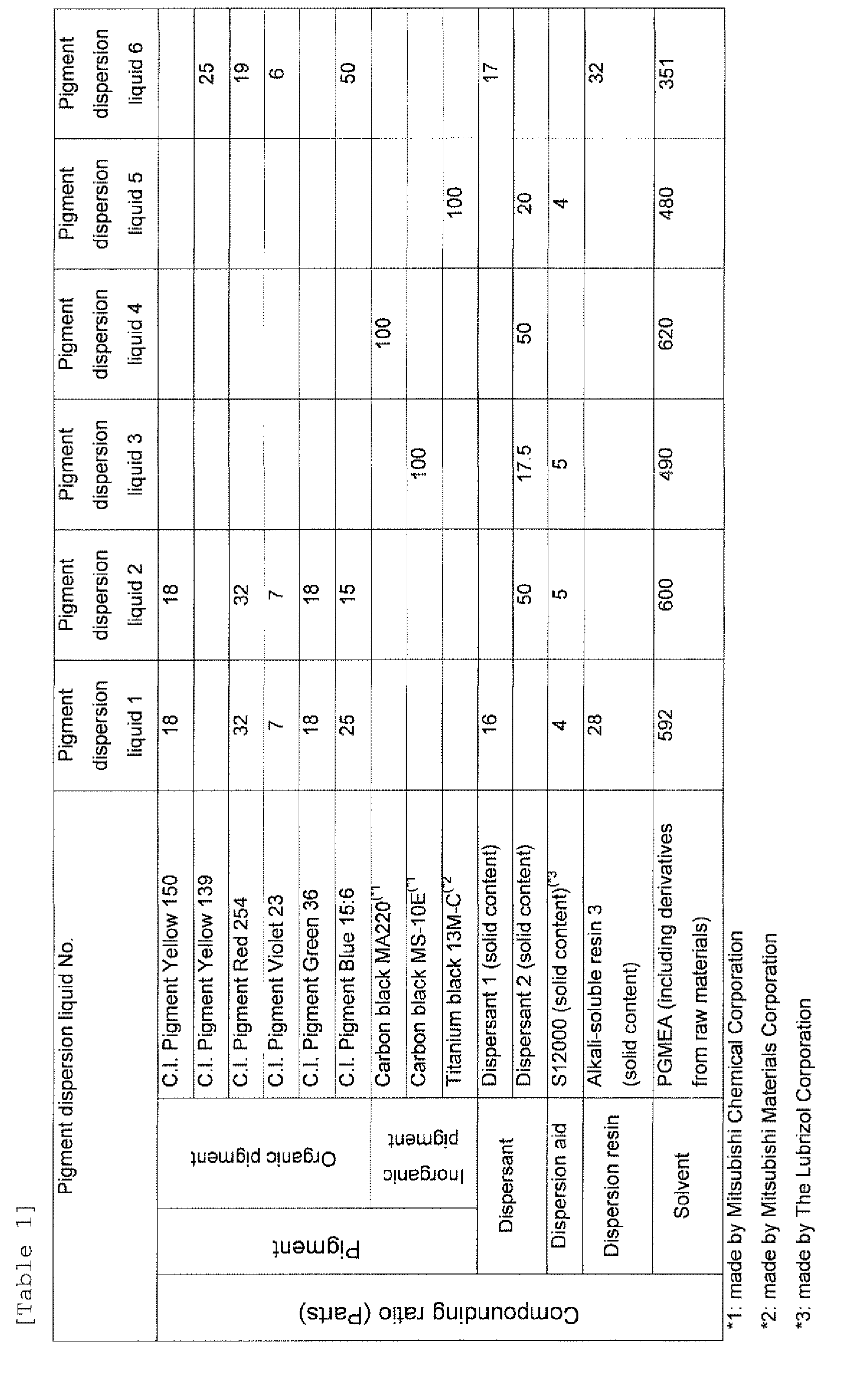

### <Examples 1 to 4 and Comparative Examples 1 to 4>

Pigment dispersion liquids 1 to 6 prepared as mentioned above and the ingredients listed in Table 2 were mixed according to the ratios shown in Table 2 and stirred to make light-blocking photosensitive resin compositions 1 to 8.

[Table 2]

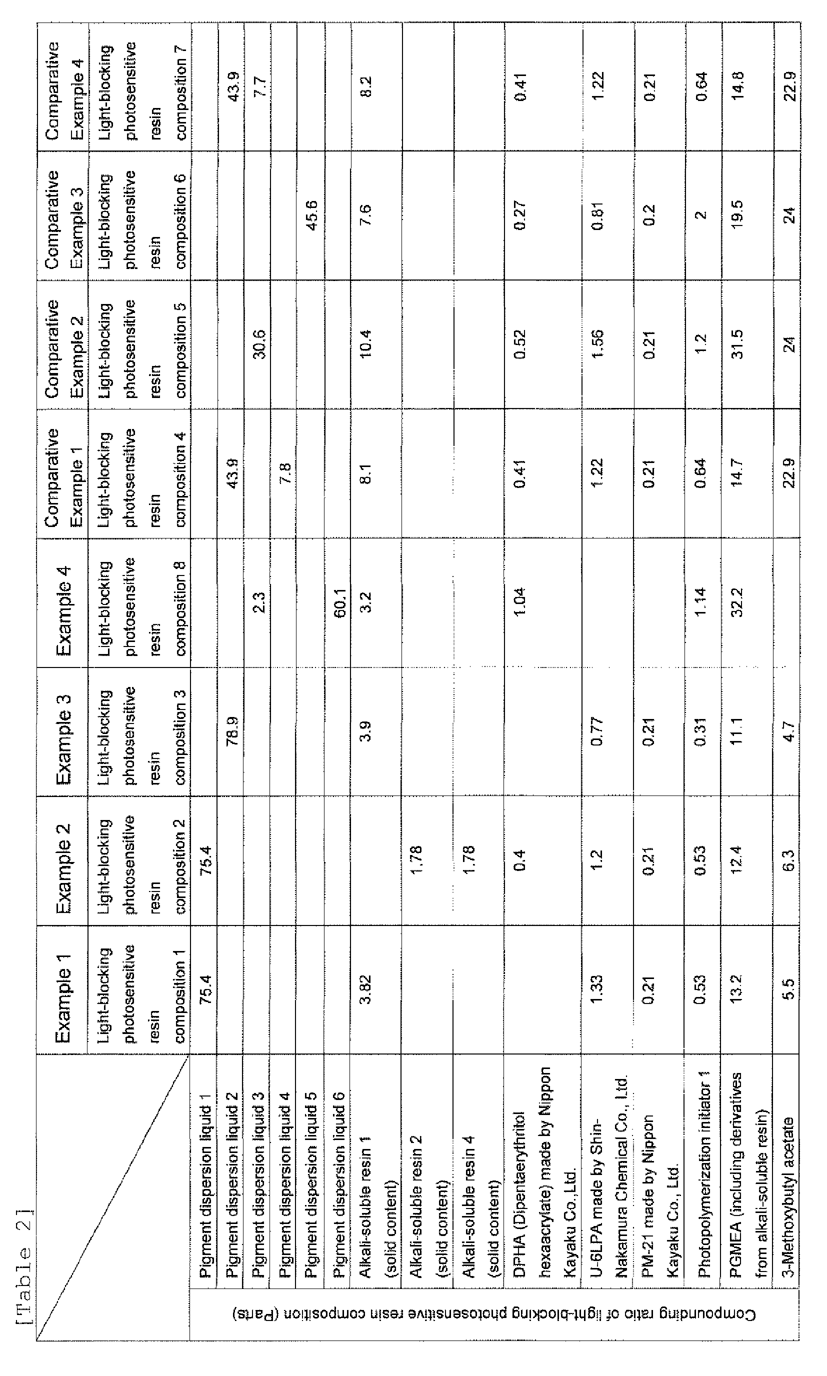

A glass substrate of 10 cm square (glass plate "AN100" for color filter made by Asahi Glass Co., Ltd.) was immersed in 1% diluted solution of silane coupling agent "KBM-603" made by Shin-Etsu Chemical Co., Ltd. for 3 minutes, washed with water for 10 seconds, and dried by air gun then in an oven for 5 minutes at 110°C. Each light-blocking photosensitive resin composition prepared according to Table 2 was applied to the glass substrate with a spin coater. The substrate was dried in a vacuum for 1 minute and then heated for 90 seconds at 90°C on a hot plate to make a dry coated film having a thickness of 3.5 µm. Then, the film was exposed by two methods, i.e., through a patterned mask composed of thin lines having a width of 15 µm (Pattern 1) and through no mask over the entire area (Pattern 2). Exposure conditions employed were 50 mJ/cm² (i-line basis) using a 3-kW high-pressure mercury lamp for each method. Subsequently, a developer of aqueous solution containing 0.05 wt% potassium hydroxide and 0.08 wt% nonionic surfactant ("A-60" made by Kao Corporation) was used for shower development under a hydraulic pressure of 0.15 MPa at 23°C. The development was stopped with pure water, and then water spray was carried out for washing. The shower development time was adjusted between 10 seconds and 120 seconds so as to be equivalent to 1.5 times the time for removal by dissolution of the unexposed coated film.

The glass substrates after formation of images were post-baked for 30 minutes at 230°C to make a glass substrate having a thin-line pattern of resin black matrix (Pattern 1) and another glass substrate having a resin black matrix on the entire area (Pattern 2). In this stage, the resin black matrix had a thickness of 3 µm.

### <Measurement of tapered angle (contact angle to substrate)>

The cross-sectional configuration of a line of the resin black matrix on the resulting glass substrates (Pattern 1) was observed with a scanning electron microscope (SEM "S-4500" made by Hitachi, Ltd.) to measure the tapered angle to the glass substrate at the contact part. The results are shown in Table 3.

### <Light transmittance>

The light transmittance of the resulting glass substrate (Pattern 2) was measured over the wavelength range from 400 nm to 3000 nm using a spectrophotometer UV-3150 made by Shimadzu Corporation with reference to a glass substrate having no coating of the light-blocking photosensitive resin composition. The measuring pitch of the wavelength was 2 nm. The maximum light transmittance and the standard deviation of the light transmittances were determined over the wavelength range from 400 nm to 700 nm, while the average light transmittance was determined over the wavelength range from 850 nm to 3000 nm. Regarding the average light transmittance, Mark A was put for the range of 85% or more, mark B was put for the range from 60% to less than 85%, and mark C was put for the range of less than 60%. Also, the minimum light transmittance was determined over the wavelength range from 850 nm to 3000 nm. Mark A was put for the range of 70% or more, mark B was put for the range from 50% to less than 70%, and mark C was put for the range of less than 50%. These results are shown in Table 3.

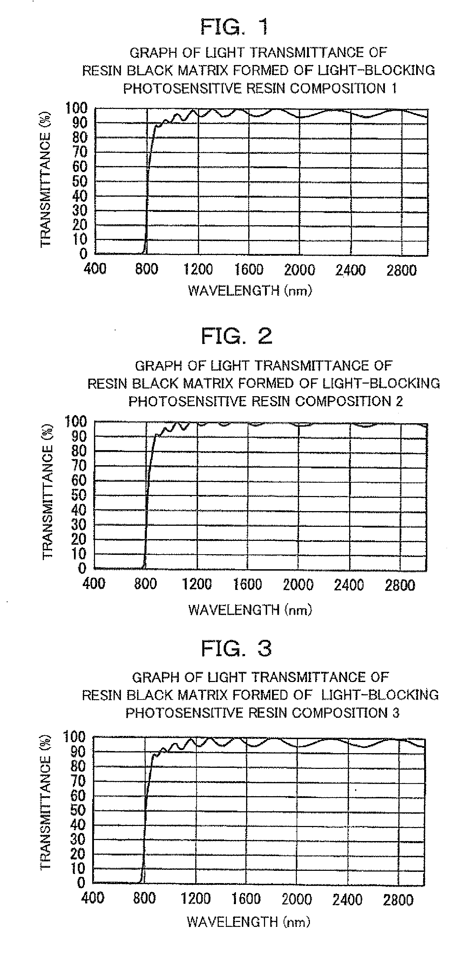

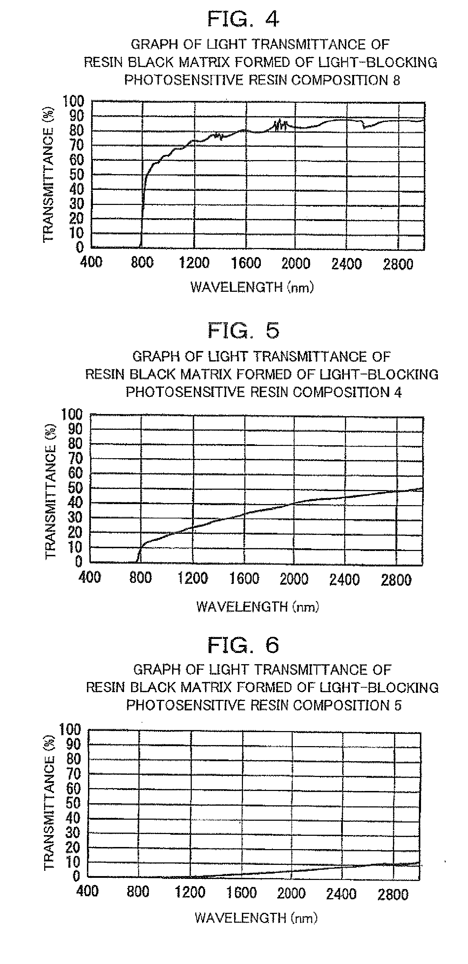

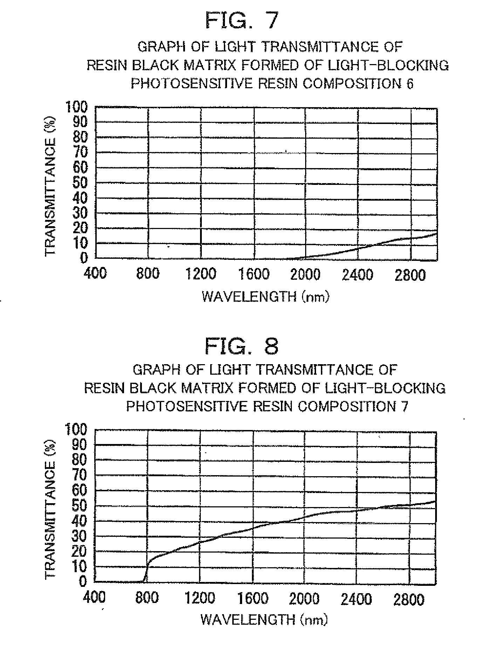

Also, an analytical sample was prepared for each light-blocking photosensitive resin composition through dilution of the composition in PGMEA into a total solid content of 300 ppm, and the light transmittance was measured over the wavelength range from 400 nm to 700 nm using a spectrophotometer UV-3150 made by Shimadzu Corporation, with reference to PGMEA. The measuring pitch of the wavelength was 2 nm. The standard deviation of light transmittances of each composition was also determined over the wavelength range from 400 nm to 700 nm. The results are shown in Table 3.
Furthermore, Figs. 1 to 8 show the relations between the wavelength and the light transmittance (%) of the resin black matrix formed by each light-blocking photosensitive resin composition. Figs. 1, 2, 3, 4, 5, 6, 7, and 8, respectively, correspond to Examples 1, 2, 3, and 4, and Comparative Examples 1, 2, 3, and 4.

### <Volume resistivity and dielectric constant>

On a glass substrate having a sputtered ITO film 150 nm thick, a resin black matrix was formed on the entire area according to the conditions mentioned above (Pattern 2) to make an ITO substrate. While the ITO substrate of this sample was used as a main electrode, a gold opposite electrode was formed on the resin black matrix by an evaporation process. Volume resistivity was determined through the measurement of a current value for an applied DC voltage of 10 V and a charging time of 30 seconds using a type 237 SMU made by Keithley Instruments Inc. The dielectric constant was determined through the measurement of an equivalent parallel capacitance at reference signal having a frequency of 1 kHz and a vibration amplitude of 1 V using a type 4284A LCR meter made by HP Company (Agilent Technologies, Inc., at present). The results are shown in Table 3.

[Table 3]

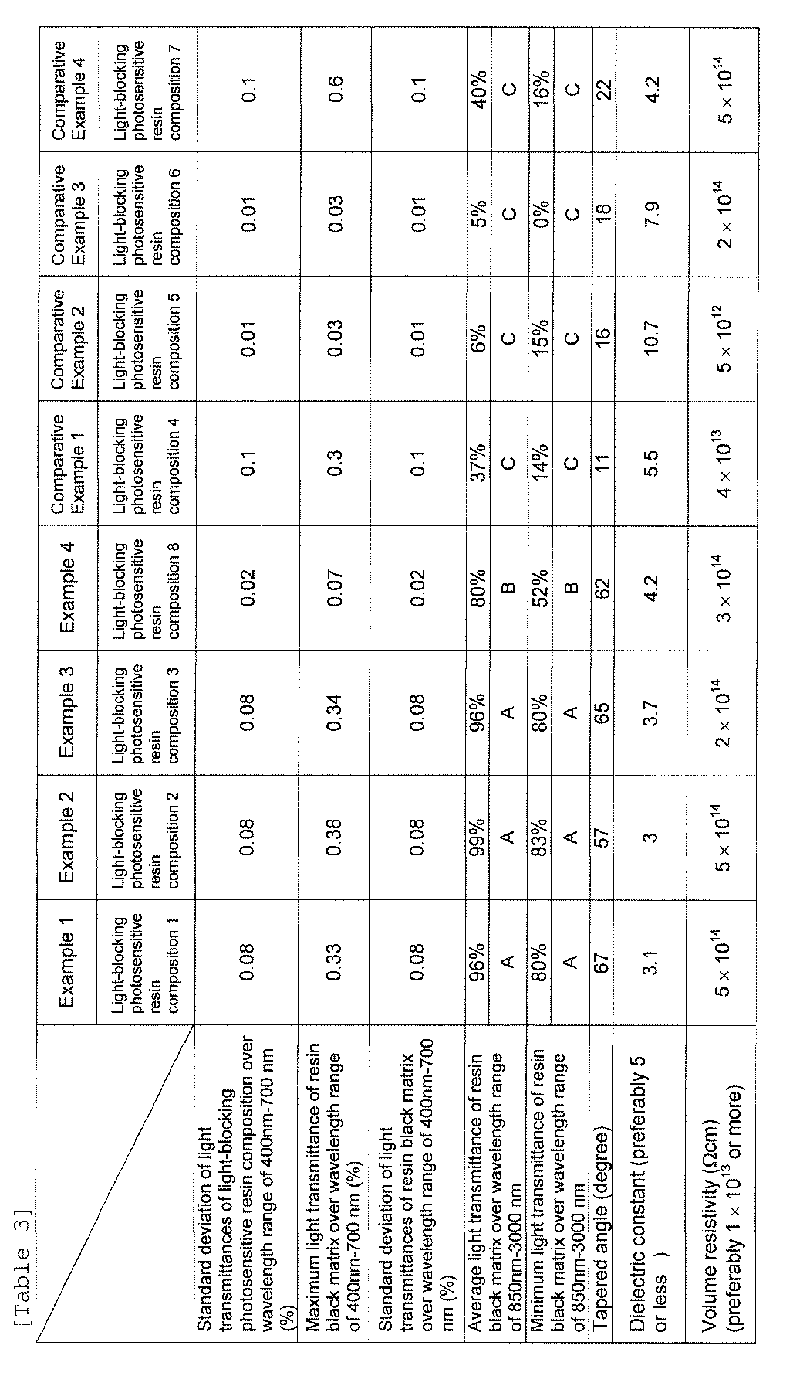

### <Industrial Applicability>

The resin black matrix and the light-blocking photosensitive resin composition of the present invention are suitable for application to a liquid crystal display device or the like, particulary preferably to a liquid crystal display device having a resin black matrix formed on a TFT element substrate.

While the present invention has been described in detail in its specific embodiments, it will be obvious to those skilled in the art that various modifications may be made without departing from the spirit and scope of the present invention. The present patent application is based on Japanese Patent Application No. 2007-215973 filed on August 22, 2007 in Japan, which is incorporated herein by reference in its entirety.

## Claims

1. A resin black matrix that has a maximum light transmittance of 1% or less over the wavelength range of 400 nm to 700 nm and an average light transmittance of 60% or more over the wavelength range of 850 nm to 3000 nm.

2. A resin black matrix that has a maximum light transmittance of 1% or less over the wavelength range of 400 nm to 700 nm and a minimum light transmittance of 50% or more over the wavelength range of 850 nm to 3000 nm.

3. A resin black matrix according to claim 1 or 2, having a standard deviation of the light transmittances of 0.1% or less over the wavelength range of 400 nm to 700 nm.

4. A resin black matrix according to any one of claims 1 to 3, having a volume resistivity of 1×10¹³ Ω·cm or more and a dielectric constant of 5 or less.

5. A resin black matrix according to any one of claims 1 to 4, being formed on a TFT element substrate.

6. A light-blocking photosensitive resin composition used for formation of the resin black matrix according to any one of claims 1 to 5, comprising:
an alkali-soluble resin, a photopolymerization initiator, an ethylenically unsaturated compound, and a light-blocking component, the content of the light-blocking component being in the range of 35 wt% to 70 wt% to the total solid content in the composition.

7. A light-blocking photosensitive resin composition according to claim 6, wherein 95% or more of the light-blocking component comprises an organic pigment.

8. A light-blocking photosensitive resin composition comprising an alkali-soluble resin, a photopolymerization initiator, an ethylenically unsaturated compound, and a light-blocking component,
wherein 95% or more of the light-blocking component comprises an organic pigment, being a combination of organic pigments selected from at least three groups of the groups (a) to (f):
(a) a red pigment selected from C.I. Pigment Reds 177, 209, 224, and 254;
(b) a blue pigment being C.I. Pigment Blue 15:6;
(c) a green pigment selected from C.I. Pigment Greens 7 and 36;
(d) a yellow pigment selected from C.I. Pigment Yellows 83, 138, 139, 150, and 180;
(e) a purple pigment being C.I. Pigment Violet 23; and
(f) an orange pigment selected from C.I. Pigment Oranges 38 and 71;
such that the composition has a standard deviation of light transmittances of 0.1% or less over the wavelength range of 400 nm to 700 nm.

9. A light-blocking photosensitive resin composition according to any one of claims 6 to 8, wherein the alkali-soluble resin contains an epoxy acrylate resin.

10. A light-blocking photosensitive resin composition according to any one of claims 6 to 9, wherein the alkali-soluble resin contains a novolak resin.

11. A light-blocking photosensitive resin composition according to any one of claims 6 to 10, wherein the photopolymerization initiator contains an oxime compound.

12. A resin black matrix fabricated from the light-blocking photosensitive resin composition according to any one of claims 6 to 11.

13. A TFT element substrate on which the resin black matrix according to any one of claims 1 to 5 and 12 is fabricated.

14. A liquid crystal display device comprising the resin black matrix according to any one of claims 1 to 5 and 12.
